(19) Europäisches Patentamt
European Patent Office
Office européen des brevets

(11) **EP 1 998 454 A1**

(12) **EUROPEAN PATENT APPLICATION**
published in accordance with Art. 158(3) EPC

(43) Date of publication:
**03.12.2008 Bulletin 2008/49**

(51) Int Cl.:
*H03M 13/19* (2006.01)   *H03M 13/47* (2006.01)
*H04J 15/00* (2006.01)

(21) Application number: **07738674.6**

(22) Date of filing: **15.03.2007**

(86) International application number:
**PCT/JP2007/055224**

(87) International publication number:
**WO 2007/108396 (27.09.2007 Gazette 2007/39)**

(84) Designated Contracting States:
**DE FR GB**

(30) Priority: **17.03.2006 JP 2006075513**

(71) Applicant: **MITSUBISHI ELECTRIC CORPORATION**
**Chiyoda-ku**
**Tokyo 100-8310 (JP)**

(72) Inventors:
• **SAKAI, Lui**
**c/o Mitsubishi Electric Corporation**
**Chiyoda-ku**
**Tokyo 1008310 (JP)**

• **MATSUMOTO, Wataru**
**c/o Mitsubishi Electric Corporation,**
**Chiyoda-ku**
**Tokyo 1008310 (JP)**
• **YOSHIDA, Hideo**
**c/o Mitsubishi Electric Corporation**
**Chiyoda-ku**
**Tokyo 1008310 (JP)**

(74) Representative: **Pfenning, Meinig & Partner GbR**
**Patent- und Rechtsanwälte**
**Theresienhöhe 13**
**80339 München (DE)**

(54) **COMMUNICATION DEVICE, DECODING DEVICE, INFORMATION TRANSMISSION METHOD, AND DECODING METHOD**

(57)    A communication device according to the present invention transmits and receives LDPC-encoded information by using MIMO technology. The communication device includes a transmission sorting unit (12) that sorts LDPC-encoded bits constituting the LDPC-encoded information in a descending order of column degree of a check matrix used for generating the LDPC-encoded bits; and a signal transmitting unit (13) that transmits the LDPC-encoded bits sorted by the transmission sorting unit (12) by allocating the LDPC-encoded bits from a transmission line having a lower noise level in sorted order.

FIG.1

EP 1 998 454 A1

**Description**

TECHNICAL FIELD

The present invention relates to a communication device that transfers an error-correction coded signal, in particular, to a communication device that transfers LDPC (low-density parity check) encoded information by using MIMO (multiple input multiple output) technology, an information transmission method, and a decoding device included in the communication device and a decoding method.

BACKGROUND ART

A conventional technology relating to the present invention is explained. Recently, data transfer using a wireless communication line is generalized, and research and development of a technique for realizing further improvement of transmission rate and transmission efficiency are under way, with an increase of chances for transferring large capacity data such as video data. MIMO (multiple input multiple output) technology is one of such techniques.

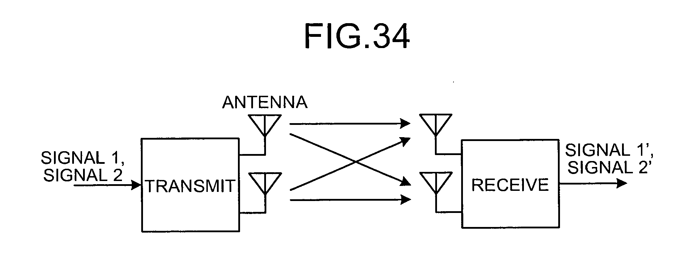

The MIMO technology is communication technology in which both communication devices on a transmission side and a reception side use a plurality of antennas for transferring signals, and includes a SDM (space division multiplexing) technique for transmitting a plurality of signal sequences in parallel and a transmission diversity technique for transmitting the same signal sequence from a plurality of antennas (see Nonpatent Literature 1). As one example, an outline of a MIMO transmission line when the transmission side and the reception side both use two antennas is shown in Fig. 34. In the MIMO transmission, because there is a plurality of transmission lines, a noise level in the respective transmission lines may be different.

Further, as one example of the error correction technique for improving the transmission efficiency, there is an error correction technique using an LDPC code, which is also used in the present invention.

The LDPC code is an error correction code having correcting capability close to a transmission line capacity, and generally has high decoding performance when a nonregular LDPC code is used, in which the number of non-zero elements in a column direction (column degree) and the number of non-zero elements in a row direction (row weight) of a check matrix are nonuniform. Further, a bit of a large column degree in the nonregular LDPC code has stronger error resilience than a bit of a small column degree.

There is a technique in which mapping is performed at the time of multilevel modulation by using nonuniformity of the error resilience depending on the column degree in the check matrix of the nonregular LDPC code (see Patent Document 1). This technique aims at averaging error rate at the time of reception, by allocating and transmitting a bit of a large column degree having the strong error resilience to a modulation point having a large noise level.

There is also a transmission power control method, which uses nonuniformity of the error resilience depending on the column degree in the check matrix of the nonregular LDPC code (see Patent Document 2). This technique aims at averaging the error rate at the time of reception, by decreasing transmission power of the bit of the large column-degree having the strong error resilience and increasing the transmission power of the bit of the small column degree to perform transmission.

Further, there is an LDPC code having a low-density generation matrix (LDGM) structure, such as a repeat accumulate (RA) code, as the nonregular LDPC code, for which encoding is easy. When this LDPC code is used, the code can be generated only by the check matrix, and a generator matrix need not be prepared.

Generation of the LDPC code is performed by using the check matrix (by using the check matrix as the generator matrix), and therefore a bit length of information to be transmitted is determined depending on the size of the check matrix. Therefore, there is an LDPC code formed by using a cyclic permutation matrix in order to make the information bit length variable. By using the cyclic permutation matrix, a variable code length is realized with a size based on the size of a fundamental matrix, for which cyclic permutation is performed.

Decoding methods of the LDPC codes include a high performance decoding method such as Sum-Product decoding method described in Nonpatent Literature 2, a decoding method aiming at decreasing an amount of calculation, and a decoding method aiming at decreasing an amount of memory. In these methods, decoding is performed by repeating predetermined row processing and column processing, parity check is performed for each repeat, and if all the parity checks are satisfied, repeat is finished and a decoding result is returned.

In decoding of the LDPC codes, there is "Horizontal Shuffled BP" as an algorithm that can reduce the number of decoding repeat (see Nonpatent Literature 3 mentioned below). In the "Horizontal Shuffled BP", by serially updating reliability in the column direction, decoding operation can be finished with a reduced number of repeat.

As a method of simplifying the processing by approximating the LDPC code with a mathematical function appearing in the decoding, there is a $\delta$-Min decoding method (see Nonpatent Literature 4). This decoding method is suitable for implementation, because arithmetic operation can be performed only with comparison, addition, and subtraction processing.

Patent Document 1: Japanese Patent Application Laid-open No. 2005-277784
Patent Document 2: Japanese Patent Application Laid-open No. 2005-39585
Nonpatent Literature 1: "100Mbit/s SDM-COFDM over MIMO Channel for Broadband Mobile Communications", Technical Report of IEICE RCS2001-135 (2001-10), p.37-42, October 2001
Nonpatent Literature 2: "Low-density parity-check codes and their decoding method LDPC (Low Density Parity Check) codes/sum-product decoding method", p.76-99, Triceps, June 5, 2002
Nonpatent Literature 3: F. Guilloud, "Generic architecture for LDPC codes", [online], <URL:http://pastel.paristech.org/archive/00000806/01/these. pdf>
Nonpatent Literature 4: L. Sakai, W. Matsumoto, H. Yoshida, "Low Complexity Decoding Algorithm for LDPC Codes and Its Discretized Density Evolution", pp13-18, RCS2005-42(2005-7) Okayama, Japan, July, 2005.

DISCLOSURE OF INVENTION

PROBLEM TO BE SOLVED BY THE INVENTION

It is known that the LDPC code has a strong resistance to nonuniform noise, a transmission line interleaver is not required, which has been necessary in the conventional error correction code, and the error correction capability is high. However, realization of further improvement of the error correction capability is still one of important problems. Further, when the conventional LDPC code decoder is mounted on a mobile communication terminal or the like, it is difficult to realize miniaturization of equipment and power saving due to too much amount of calculation required for a decoding process, and particularly, there is strong need for reduction of the amount of calculation in the equipment that performs MIMO transmission.
Further, to realize a high encoding ratio by puncturing with the LDPC codes having the LDGM structure, puncturing needs to be performed with equal intervals. However, when incremental redundancy (IR) is performed, for example, between encoding ratios 2/3 and 3/4, a discrepancy occurs, and puncturing cannot be performed with equal intervals. Further, when parity bits are punctured sequentially from the head in order to perform IR, the performance considerably deteriorates.
Further, when the LDPC code is generated by using the cyclic permutation matrix, the information bit length can be changed in a unit of size of the cyclic permutation matrix (fundamental matrix). However, when an information length, which does not match the size of the cyclic permutation matrix, is specified by a system, the information to be transmitted cannot be LDPC-encoded.
The present invention has been achieved in order to solve the above problems, and an object of the present invention is to obtain a communication device and an information transmission method that can improve the error correction capability (decoding capability).
Another object of the invention is to obtain a communication device, an information transmission method, a decoding device, and a decoding method, which reduce the amount of calculation required for decoding and realize power saving.
Still another object of the invention is to obtain a communication device and an information transmission method, which suppress performance deterioration when puncturing is performed.
Further, still another object of the invention is to obtain a communication device and an information transmission method, which can perform LDPC encoding even when the information length, which does not match the size of the cyclic permutation matrix, is specified by the system.

MEANS FOR SOLVING PROBLEM

To solve the above problems and to achieve the objects, the present invention is a communication device that transmits and receives LDPC-encoded information by using MIMO technology. The communication device includes a transmission sorting unit that sorts LDPC-encoded bits constituting the LDPC-encoded information in a descending order of column degree of a check matrix used for generating the LDPC-encoded bits; and a signal transmitting unit that transmits the LDPC-encoded bits sorted by the transmission sorting unit by allocating the LDPC-encoded bits from a transmission line having a lower noise level in sorted order.

EFFECT OF THE INVENTION

According to the present invention, a bit of a large column degree is allocated to a transmission line having a lower noise level, with respect to a difference in the noise level between transmission lines, to perform transfer. Accordingly, a communication device having high decoding capability can be realized by improving the error correction capability.

BRIEF DESCRIPTION OF DRAWINGS

[Fig. 1] Fig. 1 is a configuration example of a communication device according to a first embodiment of the present invention.

[Fig. 2] Fig. 2 is a schematic diagram of an example of a sorting process performed based on a column degree of a check matrix.

[Fig. 3] Fig. 3 is a configuration example of the communication device according to the first embodiment of the present invention.

[Fig. 4] Fig. 4 is a flowchart of one example of an operation of the communication device according to the first embodiment.

[Fig. 5] Fig. 5 is a flowchart of one example of the operation of the communication device according to the first embodiment.

[Fig. 6] Fig. 6 is one example of a calculator simulation result of information transmission performed by applying a procedure in the first embodiment.

[Fig. 7] Fig. 7 is a configuration example of a communication device according to a second embodiment of the present invention.

[Fig. 8] Fig. 8 is a configuration example of the communication device according to the second embodiment according to the present invention.

[Fig. 9] Fig. 9 is a flowchart showing one example of an operation of the communication device according to the second embodiment.

[Fig. 10] Fig. 10 is a flowchart showing one example of the operation of the communication device according to the second embodiment.

[Fig. 11] Fig. 11 is one example of a calculator simulation result of information transmission performed by applying a procedure in the second embodiment.

[Fig. 12] Fig. 12 is a configuration example of a communication device according to a third embodiment of the present invention.

[Fig. 13] Fig. 13 is a configuration example of a check matrix having an LDGM structure.

[Fig. 14] Fig. 14 is a schematic diagram of one example of a process for allocating an encoded bit to a transmission line.

[Fig. 15] Fig. 15 is a flowchart of one example of an operation of the communication device according to the third embodiment.

[Fig. 16] Fig. 16 is one example of a calculator simulation result of information transmission performed by applying a procedure in the third embodiment.

[Fig. 17] Fig. 17 is a configuration example of a communication device according to a fourth embodiment of the present invention.

[Fig. 18] Fig. 18 is a flowchart showing one example of an operation of the communication device according to the fourth embodiment.

[Fig. 19] Fig. 19 is one example of a calculator simulation result of information transmission performed by applying a procedure in the fourth embodiment.

[Fig. 20] Fig. 20 is a configuration example of a communication device according to a fifth embodiment of the present invention.

[Fig. 21] Fig. 21 is a schematic diagram of one example of a puncturing process and a depuncturing process.

[Fig. 22] Fig. 22 is a flowchart of one example of an operation of the communication device according to the fifth embodiment.

[Fig. 23-1] Fig. 23-1 is a flowchart of one example of the puncturing process.

[Fig. 23-2] Fig. 23-2 is one example of bit replacement in the puncturing process.

[Fig. 24] Fig. 24 is one example of a calculator simulation result of information transmission performed by applying a procedure in the fifth embodiment.

[Fig. 25] Fig. 25 is a configuration example of a communication device according to a sixth embodiment of the present invention.

[Fig. 26] Fig. 26 is one example of a signal transfer operation performed by the communication device according to the sixth embodiment.

[Fig. 27] Fig. 27 is a flowchart of one example of an operation of the communication device according to the sixth embodiment.

[Fig. 28] Fig. 28 is a configuration example of a decoding device included in a communication device according to a seventh embodiment.

[Fig. 29] Fig. 29 is a flowchart of one example of an operation of the decoding device according to the seventh embodiment.

[Fig. 30-1] Fig. 30-1 is an explanatory diagram of a calculation-amount reduction effect when the decoding device according to the seventh embodiment is used.

[Fig. 30-2] Fig. 30-2 is an explanatory diagram of the calculation-amount reduction effect when the decoding device according to the seventh embodiment is used.

[Fig. 30-3] Fig. 30-3 is an explanatory diagram of the calculation-amount reduction effect when the decoding device according to the seventh embodiment is used.

[Fig. 30-4] Fig. 30-4 is an explanatory diagram of the calculation-amount reduction effect when the decoding device according to the seventh embodiment is used.

[Fig. 31] Fig. 31 is a configuration example of a communication device according to an eighth embodiment of the present invention.

[Fig. 32] Fig. 32 is a flowchart of one example of an operation of the communication device according to the sixth embodiment.

[Fig. 33] Fig. 33 is a configuration example of a mobile communication system to which the communication device according to the present invention is applied.

[Fig. 34] Fig. 34 depicts an outline of a MIMO transmission line.

EXPLANATIONS OF LETTERS OR NUMERALS

| 11, 11e | LDPC encoder |
| 12 | transmission sorter |
| 13, 13b | signal transmitter |
| 14 | signal receiver |
| 15, 15a | reception sorter |
| 16, 16a, 16e | LDPC decoder |
| 21 | transmission line selector |
| 51 | puncturing unit |
| 52 | depuncturing unit |
| 61 | transmission adjusting unit |
| 62 | reception adjusting unit |
| 71 | row processor |
| 72, 72-1, 72-2, 72-3 | column processor |
| 73 | hard decision unit |
| 81 | initializing unit |
| 82 | decoding core unit |
| 83 | hard decision unit |
| 100 | mobile terminal |
| 101, 204 | physical-layer LDPC encoder |
| 102, 203 | modulator |
| 103, 202 | demodulator |
| 104, 201 | physical-layer LDPC decoder |
| 105, 205 | antenna |
| 200 | base station |
| 821 | minimum value selector |
| 822 | updating unit |
| 823 | information holding unit |

BEST MODE(S) FOR CARRYING OUT THE INVENTION

Exemplary embodiments of a communication device according to the present invention will be explained below in detail with reference to the accompanying drawings. The invention is not limited to the embodiments. Further, the present invention is directed to allocation of a transmission line to a signal sequence when an LDPC-encoded signal sequence is transferred by using the MIMO technology or the like, in transmission lines having nonuniform states. The LDPC code has originally strong resistance to nonuniform noise, as described above, and exhibits an excellent performance even with respect to a plurality of nonuniform transmission lines. However, in the case of a low encoding ratio, high decoding performance may be exhibited by emphasizing the nonuniformity. The present invention utilizes this property to realize improvement of the error correction capability.

The present invention is also applicable to data transmission performed by combining a communication device including only a transmission function (transmitter) and a communication device having only a reception function (receiver). However, in the respective embodiments described below, a communication device that includes a transmitter and a receiver and can perform two-way communication with a partner communication terminal is assumed and explained here.

First Embodiment

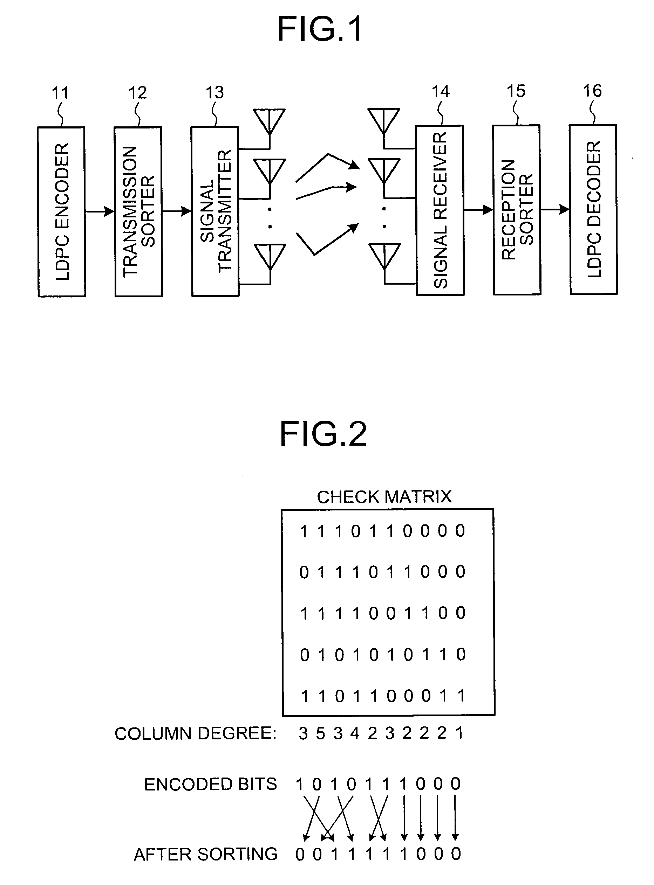

Fig. 1 is a configuration example of a communication device according to a first embodiment of the present invention. In Fig. 1, to clearly show a sender communication device and a destination communication device of a signal, the respective communication devices include only one of the transmitter and the receiver. Actually, however, the both communication devices include the transmitter and the receiver. The same applies to the configuration of the communication device in the embodiments described below.

The communication device according to the first embodiment includes the transmitter and the receiver. The transmitter includes an LDPC encoder 11 that performs LDPC encoding of transmission information, a transmission sorter 12 that sorts input signals (LDPC-encoded bits) from the LDPC encoder 11 according to distribution of the column degree (the number of non-zero elements in the column direction) of the check matrix, and a signal transmitter 13 that allocates the encoded bits sorted in the transmission sorter 12 to each transmission line to perform MIMO transmission. On the other hand, the receiver includes a signal receiver 14 that demodulates the MIMO transmission signal received via an antenna, a reception sorter 15 that sorts (sorts inversely) the demodulated received signal (received LDPC-encoded bits) so that the sequence thereof returns to the original sequence before sorting in the transmitter (the transmission sorter 12), and an LDPC decoder 16 that decodes the LDPC codes input from the reception sorter 15.

Processing in each unit is explained next. In the transmitter, the LDPC encoder 11 LDPC-encodes the input information bit (transmission information) by using the generator matrix, and outputs encoded bits obtained as a result thereof. When the LDPC codes have the LDGM structure (RA codes), the generator matrix is the same as the check matrix. The transmission sorter 12 sorts the encoded bits input from the LDPC encoder 11 in descending order of the column degree of the corresponding check matrix. The signal transmitter 13 allocates the encoded bits sorted in the transmission sorter 12 sequentially to a transmission line having a lower noise level and transmits the encoded bits. Alternatively, sorting can be performed in ascending order of the column degree and the encoded bits can be allocated to the transmission line having a higher noise level.

In the receiver, the signal receiver 14 calculates a received log likelihood ratio (LLR) based on information of the communication line through which the received signal has passed and reception information, and transmits a result thereof to the reception sorter 15. For example, when it is assumed that the communication line is an additive white Gaussian communication line, a modulation system is binary phase shift keying (BPSK), a variance of the transmission line noise is $\sigma 2$, and a received signal is $x_n$, the received LLR ($y_n$) is expressed as $y_n = 2x_n/\sigma_2$, which is information reflecting the size of the noise level in the transmission line. The variance $\sigma$ can be a value obtained beforehand as communication line information from outside or can be calculated by the signal receiver 14. The reception sorter 15 performs sorting (inverse sorting) of the received LLR so that the sequence replaced in the transmission sorter 12 of the transmitter (sequence after sorting) is returned to the original sequence of the encoded bits. The LDPC decoder 16 performs decoding based on the received LLR sorted in the reception sorter 15, and outputs the decoded bits. The decoding process performed by the LDPC decoder 16 can be any process, so long as it has an algorithm for decoding the LDPC codes.

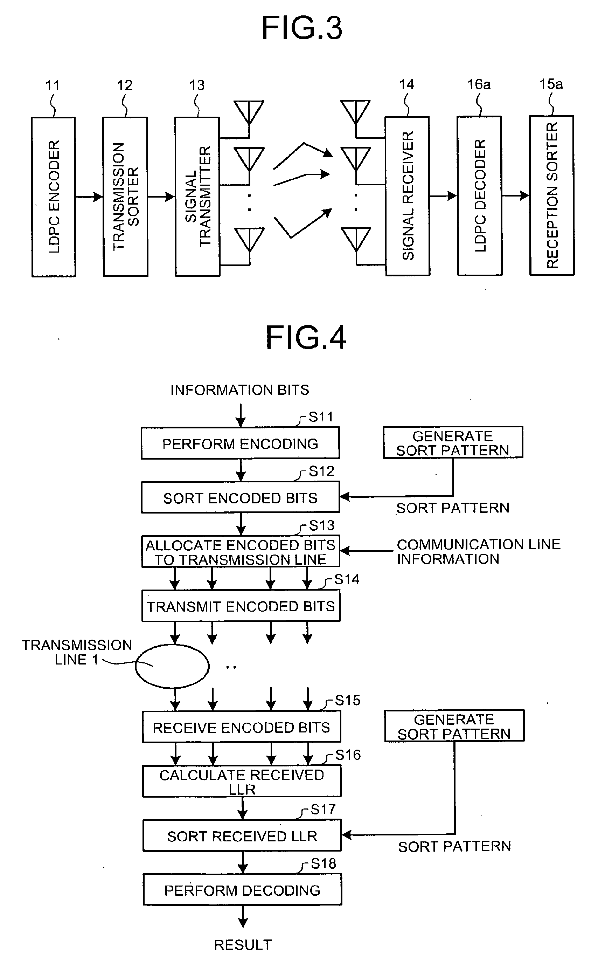

The receiver can perform a decoding process by using a matrix in which column order of the check matrix used in the LDPC decoder 16 is rearranged according to the order of sort performed by the transmission sorter 12 in the transmitter, and thereafter, the decoded bits can be sorted. In this case, the configuration of the communication device (receiver) is as shown in Fig. 3. Therefore, because a reception sorter 15a needs to sort only the bits decoded by an LDPC decoder 16a, the number of processes for replacing the sequence is reduced.

A signal transfer operation is explained next. Fig. 4 is a flowchart of one example of an operation of the communication device according to the first embodiment. The operation is explained with reference to Fig. 4. The LDPC encoder 11 in the communication device on the transmission side (transmitter) first encodes transmission information (information bits) by using a predetermined generator matrix (Step S11). The transmission sorter 12 then sorts the encoded bits generated in the LDPC encoder 11 by using a sort pattern prepared beforehand (Step S12). The sort pattern to be used here is a pattern determined based on the column degree of the check matrix corresponding to the encoded bit generated in the LDPC encoder 11 so that the encoded bits are arranged in a weight order of the column degree. The signal transmitter 13 ascertains the noise state of the transmission line beforehand as the communication line information, and allocates and transmits a signal (encoded bit) to a transmission line with good noise state in descending order of the column degree of the check matrix (Steps S13 and S14). For the signal transmitter 13 to ascertain the noise state, there are several methods such as transmitting a pilot signal beforehand to measure the transmission line and using the transmission line information obtained as the communication system. When multilevel modulation is performed in each transmission line, the noise level is different for each modulation point. In this case, the encoded bit can be allocated, ignoring a change in the noise level due to the modulation point, or the encoded bit can be allocated with a noise level taking the modulation point into consideration.

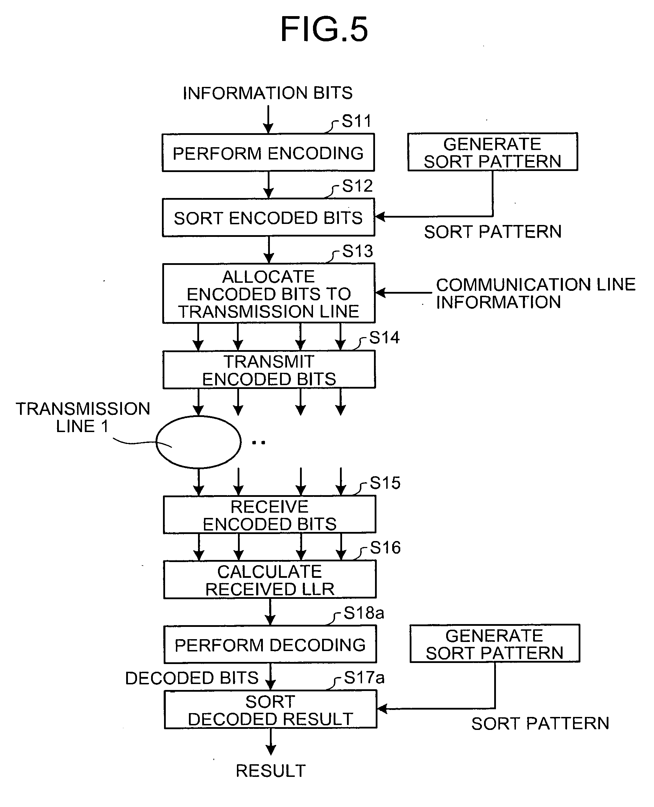

In the communication device on the reception side (receiver), upon reception of a signal (Step S15), the signal receiver 14 calculates the received LLR based on the information of the communication line through which the received signal has passed (noise level for each transmission line) and the reception information (Step S16). The reception sorter 15 uses the sort pattern prepared beforehand to sort the received LLR calculated by the signal receiver 14 (Step S17). The sort pattern to be used here is the same as the sort pattern used by the transmission sorter 12 on the transmission side, based on the column degree of the check matrix. The LDPC decoder 16 then performs decoding based on the sorted received LLR output from the reception sorter 15 (Step S18). When the communication device has the configuration shown in Fig. 3, as shown in Fig. 5, the LDPC decoder 16a uses a matrix prepared beforehand in which the columns in the check matrix are sorted based on the column degree, to execute decoding based on the received LLR (Step S18a), and the reception sorter 15a sorts the decoded bit obtained as a result (Step S17a). In this case, because only the decoded information bits are sorted, the number of processes for replacing the sequence is reduced than a case that the encoded bits having a size of the code length are sorted.

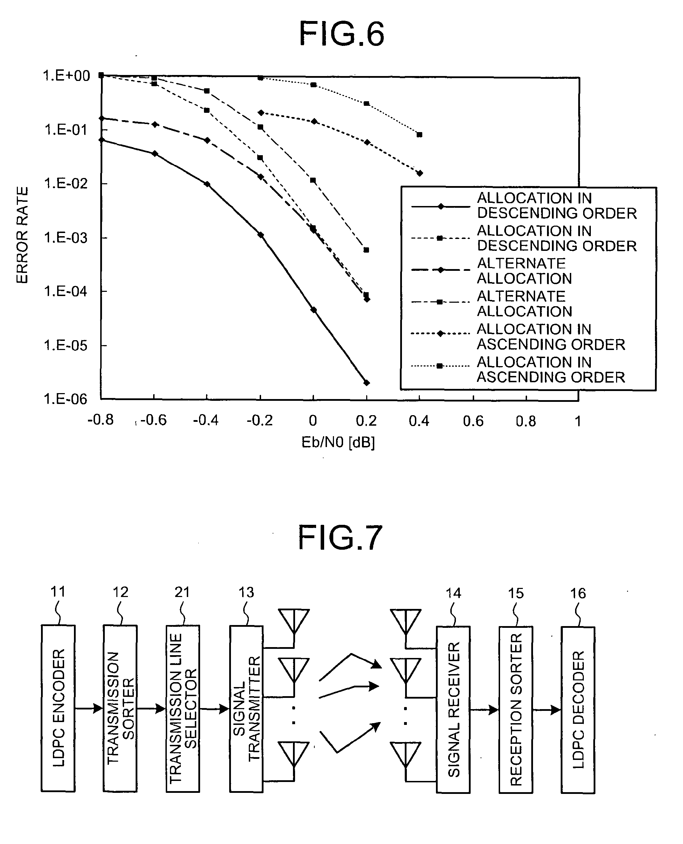

One example of a calculator simulation result of information transmission using the above procedure is shown in Fig. 6. Fig. 6 is one example of the calculator simulation result performed under such a condition that the encoded bits are allocated to four transmission lines having different noise levels, designating the encoding ratio as 1/3, in such a manner that the encoded bit of a higher column degree is allocated to a transmission line having a lower noise level. The four transmission lines correspond to a case that four transmitting antennas and four receiving antennas are used in communication according to the MIMO technology. For comparison, Fig. 6 also depicts a simulation result when the sequence of allocating the signal to the transmission line is reversed with respect to the present embodiment (allocated from a bit having a lower column degree to a transmission line having a lower noise level in order), and a simulation result when an information bit and a parity bit are alternately allocated to each transmission line, as an example of a transmission process performed without taking into consideration the influence of the column degree.

The condition for obtaining the example of the calculator simulation result shown in Fig. 6 is such that the four transmission lines are additive white Gaussian communication lines having the information length of 1440 bits and the encoding ratio of 1/3, in which the modulation system is BPSK, the signal-to-noise ratio Eb/N0 is shifted from a mean value by (-4.5, -1.5, 1.5, and 4.5) [dB] respectively, the decoding method of the LDPC code is Sum-Product decoding method, and the number of repeat is 100 times. In Fig. 6, the result obtained by sequentially allocating the encoded bit of a higher column degree to a transmission line having a lower noise level is referred to as "allocation in descending order", the result obtained by sequentially allocating the encoded bit having a lower column degree to a transmission line having a lower noise level is referred to as "allocation in ascending order", and the result obtained by allocating the information bit and the parity bit alternately to a transmission line having a lower noise level sequentially is referred to as "alternate allocation". A mean value of Eb/N0 of the four transmission lines (for example, if the four transmission lines are -4.2, -1.2, 1.8, and 4.8, respectively, the mean value is 0.3) is plotted on X axis, and the error rate is plotted on Y axis, solid line denotes bit error rate, and broken line denotes block error rate. It is seen from the results shown in Fig. 6 that the "allocation in descending order" has the highest decoding performance.

First, a parity check matrix $H_{QCL}$ of QC-LDPC codes with the LDGM structure, which is a premise for the irregular parity check matrix $H_M$ after the masking processing and is generated by the check matrix generation processing of the present embodiment, will be defined.

For example, the parity check matrix $H_{QCL}$ ($=[h_{m,n}]$) of the QC-LDPC codes with the LDGM structure of M ($=pJ$) rows x N ($=pL+pJ$) columns can be defined as following Equation (1). Here, $h_{m,n}$ represents an element at a row index m and a column index n in the parity check matrix $H_{QCL}$.

[Numerical Expression 1]

$$H_{QCL} := \begin{bmatrix} I(p_{0,0}) & I(p_{0,1}) & \cdots & I(p_{0,L-1}) & I(0) & 0 & \cdots & \cdots & \cdots & \cdots & \cdots & 0 \\ I(p_{1,0}) & I(p_{1,2}) & \cdots & I(p_{1,L-1}) & I(0) & I(0) & 0 & \ddots & \ddots & \ddots & \ddots & \vdots \\ \vdots & \vdots & \vdots & \vdots & 0 & \ddots & \ddots & \ddots & \ddots & \ddots & \ddots & \vdots \\ I(p_{J/2-1,0}) & I(p_{J/2-1,2}) & \cdots & I(p_{J/2-1,L-1}) & \vdots & \ddots & I(0) & I(0) & 0 & \ddots & \ddots & \vdots \\ \vdots & \vdots & \vdots & \vdots & I(0) & 0 & \cdots & 0 & I(0) & 0 & \ddots & \vdots \\ \vdots & \vdots & \vdots & \vdots & 0 & I(0) & 0 & \ddots & \ddots & I(0) & \ddots & \vdots \\ \vdots & \vdots & \vdots & \vdots & \vdots & \ddots & \ddots & \ddots & \ddots & \ddots & \ddots & 0 \\ I(p_{J-1,0}) & I(p_{J-1,2}) & \cdots & I(p_{J-1,L-1}) & 0 & \cdots & 0 & I(0) & 0 & \cdots & 0 & I(0) \end{bmatrix} \quad \ldots (1)$$

Additionally, in $0 \le j \le J-1$ and $0 \le 1 \le L-1$, I $(p_{j,1})$ are cyclic permutation matrices in which positions of a row index: r ($0 \le r \le p-1$), and a column index: "$(r+p_{j,1})$mod p" are "1", and other positions are "0". For example, I (1) can be represented as following Equation (2).

[Numerical Expression 2]

$$I(1) = \begin{bmatrix} 0 & 1 & 0 & \cdots & 0 \\ 0 & 0 & 1 & \cdots & 0 \\ \cdots & \cdots & \cdots & \cdots & \cdots \\ 0 & 0 & 0 & \cdots & 1 \\ 1 & 0 & 0 & \cdots & 0 \end{bmatrix} \qquad \ldots (2)$$

In the parity check matrix $H_{QCL}$, a left-hand side matrix (a portion corresponding to data bits) is a quasi-cyclic matrix $H_{QC}$ that is the same as the parity check matrix of QC codes shown by Equation (2), and a right-hand side matrix (a portion corresponding to parity bits) is a matrix $H_T$ or $H_D$ in which I(0) are arranged in a staircase manner as shown in following Equation (3) or Equation (4).

[Numerical Expression 3]

$$H_T := \begin{bmatrix} I(0) & 0 & \cdots & \cdots & \cdots & \cdots & \cdots & 0 \\ I(0) & I(0) & 0 & \ddots & \ddots & \ddots & \ddots & \vdots \\ 0 & \ddots & \ddots & \ddots & \ddots & \ddots & \ddots & \vdots \\ \vdots & \ddots & I(0) & I(0) & 0 & \ddots & \ddots & \vdots \\ I(0) & 0 & \cdots & 0 & I(0) & 0 & \ddots & \vdots \\ 0 & I(0) & 0 & \ddots & \ddots & I(0) & \ddots & \vdots \\ \vdots & \ddots & \ddots & \ddots & \ddots & \ddots & \ddots & 0 \\ 0 & \cdots & 0 & I(0) & 0 & \cdots & 0 & I(0) \end{bmatrix} \qquad \ldots (3)$$

[Numerical Expression 4]

$$H_D := \begin{bmatrix} I(0) & 0 & \cdots & \cdots & 0 \\ I(0) & I(0) & 0 & \ddots & \vdots \\ 0 & \ddots & \ddots & \ddots & \vdots \\ \vdots & \ddots & I(0) & I(0) & 0 \\ 0 & \cdots & 0 & I(0) & I(0) \end{bmatrix} \qquad \ldots (4)$$

The LDGM structure means a structure in which a part of the parity check matrix is formed into a lower triangular matrix as the matrix shown in Equation (3). Further, in the present embodiment, a specific regularity is provided in the parity check matrix $H_{QCL}$ of the QC-LDPC codes with the LDGM structure defined as Equation (3). Specifically, in the quasi-cyclic matrix $H_{QC}$ portion on the left-hand side of the parity check matrix $H_{QCL}$, if $p_{0,1}$ is set to an arbitrary integer, a specific regularity is provided to $p_{j,1}$ of the cyclic permutation matrices I $(p_{j,1})$ with p-row x p-column arranged at a row index j (=0, 1, 2, ..., J-1) and a column index 1 (=0, 1, 2, ..., L-1) so as to satisfy Equation (5) and Equation (6).
$$p_A = 157$$

$$0 \leq j \leq j - 1$$

$$p: \text{ odd number} \qquad \ldots (5)$$

$$P'_{0,0}=61, \quad p'_{0,1}=39, \quad p'_{0,2}=21, \quad p'_{0,3}=41, \quad p'_{0,4}=6,$$

$$p'_{0,5}=40, \quad p'_{0,6}=1, \quad p'_{0,7}=37, \quad p'_{0,8}=3, \quad p'_{0,9}=34, \quad p'_{0,10}=26,$$

$$p'_{0,11}=10, \quad p'_{0,12}=22, \quad p'_{0,13}=16, \quad p'_{0,14}=37, \quad p'_{0,15}=17, \quad p'_{0,16}=25,$$

$$p'_{0,17}=23, \quad p'_{0,18}=12, \quad p'_{0,19}=1, \quad p'_{0,20}=10, \quad p'_{0,21}=14, \quad p'_{0,22}=32,$$

$$p'_{0,23}=30, \quad p'_{0,}24=6, \quad p'_{0,25}=24, \quad p'_{0,26}=25, \quad p'_{0,27}=26, \quad p'_{0,28}=27,$$

$$p'_{0,29}=28, \quad p'_{0,30}=29, \quad p'_{0,31}=31 \qquad \ldots (6)$$

The combination of numerical values shown in Equation (6) is one example only, and an optimum combination (the combination capable of obtaining the highest decoding performance) is used according to the condition by performing simulation.
Masking processing with respect to a parity check matrix $H_{QCL}$, which is characteristic processing in check matrix generation processing is explained next. For example, when the left-hand side matrix shown in Equation (3) is represented by the quasi-cyclic matrix $H_{QC}$ of J x L as shown in following Equation (7), and a mask matrix Z $(=[z_{j,1}])$ is defined as a matrix with J-row x L-column on GF(2), the matrix $H_{MQC}$ after the mask processing can be represented as following Equation (8) if a predetermined rule described below is applied.
[Numerical Expression 5]

$$H_{QC} := \begin{bmatrix} I(p_{0,0}) & I(p_{0,1}) & \cdots & I(p_{0,L-1}) \\ I(p_{1,0}) & I(p_{1,1}) & \cdots & I(p_{1,L-1}) \\ \vdots & \vdots & \ddots & \vdots \\ I(p_{J-1,0}) & I(p_{J-1,1}) & \cdots & I(p_{J-1,L-1}) \end{bmatrix} \quad \ldots (7)$$

[Numerical Expression 6]

$$H_{MQC} = Z \otimes H_{QC} = \begin{bmatrix} z_{0,0}I(p_{0,0}) & z_{0,1}I(p_{0,1}) & \cdots & z_{0,L-1}I(p_{0,L-1}) \\ z_{1,0}I(p_{1,0}) & z_{1,1}I(p_{1,1}) & \cdots & z_{1,L-1}I(p_{1,L-1}) \\ \vdots & \vdots & \ddots & \vdots \\ z_{J-1,0}I(p_{J-1,0}) & z_{J-1,1}I(p_{J-1,1}) & \cdots & z_{J-1,L-1}I(p_{J-1,L-1}) \end{bmatrix} \ldots (8)$$

Here, $z_{j,}$ II$(p_{j,1})$ in Equation (8) is defined as following Equation (9).
[Numerical Expression 7]

$$z_{j,l}I(p_{j,l}) = \begin{cases} I(p_{j,l}) & for \ z_{j,l} = 1 \\ 0 \ matrix & for \ z_{j,l} = 0 \end{cases} \quad \ldots (9)$$

The zero-matrix in Equation (9) is a zero-matrix with p-row x p-column. Additionally, the matrix $H_{MQC}$ is a matrix in which the quasi-cyclic matrix $H_{QC}$ is masked with 0-elements of the mask matrix Z, and the weight distribution is nonuniform, while a distribution of the cyclic permutation matrices of the matrix $H_{MQC}$ is the same as a degree distribution of the mask matrix Z. Note that a weight distribution of the mask matrix Z when the weight distribution is nonuniform shall be determined by a predetermined density evolution method as known. For example, the mask matrix with 64-row x 32-column can be represented as following Equation (10) based on a column degree distribution by the density evolution method.
[Numerical Expression 8]

$$Z = \begin{bmatrix} Z^A \\ \hline Z^A(1:32,2:5) \ Z^A(1:32,1) \ Z^A(1:32,7:16) \ 0_{32 \times 17} \end{bmatrix} \quad \ldots (10)$$

Further, the mask matrix $Z^A$ is shown in following Equation (11). $Z^A(1:32, 2:5)$ is submatrices of $Z^A$, which indicates submatrices formed of the 1st row to the 32nd row and the 2nd column to the 5th column.
[Numerical Expression 9]

$$Z^A = \begin{bmatrix}
1 & 1 & 0 & 0 & 0 & 0 & 0 & 0 & 0 & 0 & 1 & 0 & 0 & 0 & 0 & 1 & 0 & 0 & 0 & 0 & 0 & 0 & 0 & 0 & 0 & 0 & 1 & 0 & 0 & 0 \\
0 & 0 & 1 & 0 & 1 & 0 & 0 & 1 & 0 & 0 & 0 & 0 & 0 & 0 & 0 & 0 & 0 & 0 & 0 & 1 & 0 & 0 & 1 & 0 & 0 & 0 & 0 & 0 & 0 & 0 \\
0 & 1 & 0 & 1 & 0 & 1 & 0 & 0 & 0 & 0 & 0 & 0 & 0 & 1 & 0 & 0 & 0 & 0 & 1 & 0 & 0 & 0 & 0 & 0 & 0 & 0 & 0 & 0 & 0 & 1 \\
1 & 1 & 0 & 0 & 0 & 0 & 1 & 0 & 0 & 0 & 0 & 0 & 0 & 0 & 0 & 0 & 0 & 1 & 0 & 0 & 0 & 0 & 0 & 0 & 0 & 1 & 0 & 0 & 0 \\
1 & 0 & 1 & 0 & 1 & 0 & 0 & 0 & 0 & 0 & 1 & 0 & 0 & 0 & 0 & 0 & 0 & 0 & 1 & 0 & 1 & 0 & 0 & 0 & 0 & 0 & 0 & 0 & 0 \\
0 & 0 & 0 & 1 & 1 & 0 & 0 & 0 & 0 & 0 & 1 & 0 & 0 & 0 & 0 & 0 & 0 & 1 & 0 & 0 & 0 & 0 & 0 & 1 & 0 & 0 & 0 & 0 & 0 & 0 & 0 \\
0 & 1 & 0 & 0 & 1 & 0 & 0 & 0 & 0 & 0 & 0 & 0 & 1 & 0 & 0 & 0 & 1 & 0 & 0 & 1 & 0 & 0 & 0 & 0 & 0 & 0 & 0 & 0 & 0 & 1 & 0 \\
0 & 1 & 1 & 0 & 0 & 0 & 0 & 0 & 0 & 0 & 0 & 0 & 0 & 0 & 0 & 0 & 0 & 0 & 0 & 0 & 0 & 1 & 0 & 0 & 0 & 1 & 0 & 0 & 0 \\
1 & 0 & 0 & 1 & 0 & 0 & 0 & 0 & 1 & 0 & 0 & 0 & 0 & 0 & 0 & 1 & 0 & 0 & 0 & 0 & 0 & 0 & 0 & 0 & 1 & 0 & 0 & 0 & 0 & 0 & 0 \\
1 & 1 & 0 & 1 & 1 & 0 & 0 & 0 & 0 & 0 & 0 & 1 & 0 & 0 & 0 & 0 & 1 & 1 & 0 & 0 & 0 & 0 & 0 & 0 & 0 & 0 & 0 & 0 & 0 & 1 \\
0 & 1 & 1 & 0 & 0 & 0 & 1 & 0 & 0 & 0 & 0 & 0 & 0 & 0 & 1 & 0 & 0 & 0 & 0 & 0 & 0 & 0 & 0 & 0 & 0 & 0 & 0 & 1 & 0 \\
1 & 0 & 0 & 1 & 0 & 0 & 0 & 0 & 0 & 0 & 0 & 0 & 0 & 1 & 0 & 0 & 0 & 0 & 0 & 0 & 1 & 0 & 1 & 0 & 0 & 0 & 0 & 0 & 0 \\
1 & 1 & 0 & 0 & 0 & 0 & 0 & 0 & 1 & 0 & 0 & 0 & 0 & 0 & 0 & 1 & 0 & 0 & 0 & 1 & 0 & 0 & 0 & 0 & 0 & 1 & 0 & 0 & 0 & 0 \\
1 & 0 & 1 & 0 & 0 & 0 & 1 & 0 & 0 & 0 & 0 & 0 & 0 & 0 & 0 & 0 & 0 & 0 & 0 & 0 & 0 & 0 & 0 & 0 & 0 & 0 & 0 & 1 & 0 & 0 \\
1 & 0 & 0 & 1 & 1 & 0 & 0 & 0 & 0 & 0 & 0 & 0 & 0 & 1 & 0 & 1 & 0 & 0 & 0 & 0 & 0 & 0 & 0 & 0 & 0 & 0 & 0 & 0 & 0 & 0 \\
0 & 1 & 0 & 1 & 0 & 1 & 0 & 1 & 0 & 0 & 0 & 0 & 0 & 0 & 0 & 0 & 0 & 0 & 1 & 0 & 1 & 0 & 0 & 0 & 0 & 0 & 0 & 0 & 0 \\
1 & 0 & 1 & 0 & 0 & 0 & 0 & 0 & 0 & 1 & 0 & 0 & 1 & 0 & 0 & 0 & 0 & 0 & 0 & 0 & 0 & 0 & 1 & 0 & 0 & 0 & 1 & 0 & 0 & 0 & 0 \\
1 & 0 & 0 & 1 & 0 & 0 & 0 & 0 & 0 & 0 & 0 & 0 & 0 & 1 & 0 & 0 & 0 & 0 & 0 & 0 & 0 & 0 & 0 & 0 & 1 & 0 & 0 & 0 & 0 & 0 & 0 \\
0 & 1 & 0 & 0 & 1 & 1 & 0 & 0 & 0 & 0 & 1 & 0 & 0 & 0 & 0 & 0 & 0 & 0 & 1 & 0 & 0 & 0 & 0 & 0 & 0 & 0 & 0 & 1 & 0 & 0 \\
1 & 0 & 1 & 0 & 0 & 0 & 0 & 0 & 0 & 1 & 0 & 0 & 0 & 0 & 0 & 1 & 0 & 0 & 0 & 0 & 0 & 0 & 0 & 0 & 0 & 0 & 0 & 0 & 0 & 1 \\
0 & 0 & 1 & 1 & 0 & 0 & 0 & 0 & 0 & 0 & 0 & 0 & 0 & 1 & 0 & 0 & 0 & 0 & 0 & 1 & 1 & 0 & 0 & 0 & 0 & 0 & 0 & 0 & 0 \\
1 & 1 & 0 & 0 & 0 & 0 & 0 & 0 & 0 & 0 & 0 & 0 & 1 & 0 & 0 & 0 & 0 & 1 & 0 & 0 & 0 & 0 & 0 & 0 & 0 & 0 & 0 & 0 & 1 & 0 \\
0 & 0 & 1 & 0 & 1 & 0 & 0 & 0 & 0 & 0 & 0 & 0 & 0 & 0 & 0 & 0 & 0 & 1 & 0 & 0 & 0 & 0 & 0 & 1 & 0 & 0 & 0 & 0 & 0 & 0 \\
1 & 0 & 0 & 1 & 1 & 0 & 0 & 0 & 0 & 0 & 0 & 0 & 0 & 0 & 0 & 0 & 0 & 1 & 0 & 0 & 0 & 1 & 0 & 0 & 0 & 0 & 0 & 0 & 0 \\
0 & 1 & 0 & 0 & 0 & 0 & 0 & 0 & 1 & 1 & 0 & 1 & 0 & 0 & 0 & 0 & 0 & 0 & 0 & 0 & 0 & 0 & 0 & 0 & 1 & 0 & 0 & 0 & 0 & 0 \\
1 & 0 & 1 & 0 & 0 & 0 & 0 & 1 & 0 & 0 & 1 & 0 & 0 & 0 & 0 & 0 & 1 & 0 & 0 & 0 & 0 & 0 & 0 & 0 & 0 & 0 & 0 & 0 & 0 \\
0 & 0 & 0 & 1 & 1 & 0 & 0 & 0 & 0 & 0 & 0 & 0 & 0 & 1 & 0 & 1 & 0 & 0 & 0 & 0 & 0 & 0 & 1 & 0 & 0 & 0 & 0 & 0 \\
1 & 1 & 0 & 0 & 0 & 0 & 0 & 0 & 0 & 0 & 0 & 1 & 0 & 0 & 0 & 0 & 0 & 0 & 1 & 0 & 0 & 0 & 0 & 0 & 0 & 1 & 0 & 0 \\
1 & 0 & 1 & 0 & 0 & 0 & 1 & 0 & 0 & 0 & 0 & 0 & 0 & 0 & 0 & 1 & 0 & 0 & 0 & 0 & 1 & 0 & 1 & 0 & 0 & 0 & 0 & 0 & 0 \\
0 & 0 & 0 & 1 & 0 & 0 & 0 & 0 & 1 & 0 & 0 & 0 & 0 & 0 & 0 & 0 & 0 & 0 & 1 & 0 & 0 & 0 & 0 & 0 & 0 & 0 & 0 & 0 \\
0 & 1 & 1 & 0 & 1 & 0 & 0 & 1 & 1 & 0 & 0 & 0 & 1 & 0 & 0 & 0 & 0 & 0 & 0 & 0 & 0 & 0 & 0 & 1 & 0 & 0 & 0 & 0 & 0 \\
0 & 0 & 1 & 0 & 1 & 1 & 0 & 0 & 0 & 0 & 1 & 0 & 0 & 0 & 0 & 0 & 0 & 1 & 0 & 0 & 0 & 0 & 0 & 0 & 1 & 0 & 0 & 0 & 0
\end{bmatrix} \quad \dots (11)$$

Hence, the irregular check matrix $H_M$ to be finally determined in the present embodiment can be represented as following Equation (12) using, for example, the mask matrix Z with 64-row x 32-column, the quasi-cyclic matrix $H_{QC}$ with 64 (row index j is 0 to 63) x 32 (column index 1 is 0 to 31), and $H_T$ of 64 (row index j is 0 to 63) x 64 (column index 1 is 0 to 63).

$$H_M = [\, Z \times H_{QC} | H_T \,]$$

$$= [\, H_{MQC} | H_T \,] \qquad \dots (12)$$

Namely, the parity check matrix $H_{MQC}$ for generating the LDPC codes C is given by a design of the mask matrix Z and a value of the cyclic permutation matrix at the row index j=0 of the quasi-cyclic matrix $H_{QC}$. To generate a check matrix corresponding to the information length 1440 bits used for obtaining the calculator simulation result shown in Fig. 6 according to this procedure, p can be set to p=45.

Another example of the check matrix is shown. The check matrix is formed by extending the LDPC codes conforming to IEEE (Institute of Electrical and Electronics Engineers) 802.16e Standard (encoding ratio 1/2) to 1/3. As described above, the check matrix includes QC-LDPC codes having the LDGM structure, and a cyclic permutation number p(z, i, j) is determined based on an element p(i, j) in the matrix shown in following equation (13) and a unit z of the cyclic permutation matrix, using p(z, i, j)=floor(p(i, j)xz/96). Here, floor(x) indicates the largest integer not exceeding x. Further, in an element -1, the cyclic permutation matrix is zero matrix (the same as the above mask matrix. For example, the element in the 0th column and the 1st row when z=24 becomes floor(94xz/96)=23.

[Numerical Expression 10]

$$
\begin{bmatrix}
-1 & 94 & 73 & -1 & -1 & -1 & -1 & -1 & 55 & 83 & -1 & -1 & 7 & 0 & -1 & -1 & -1 & -1 & -1 & -1 & -1 & -1 & -1 & -1 & -1 & -1 & -1 & -1 & -1 & -1 & -1 & -1 & -1 & -1 \\
-1 & 27 & -1 & -1 & -1 & 22 & 79 & 9 & -1 & -1 & -1 & 12 & -1 & 0 & 0 & -1 & -1 & -1 & -1 & -1 & -1 & -1 & -1 & -1 & -1 & -1 & -1 & -1 & -1 & -1 & -1 & -1 & -1 & -1 \\
-1 & -1 & -1 & 24 & 22 & 81 & -1 & 33 & -1 & -1 & -1 & 0 & -1 & -1 & 0 & 0 & -1 & -1 & -1 & -1 & -1 & -1 & -1 & -1 & -1 & -1 & -1 & -1 & -1 & -1 & -1 & -1 & -1 & -1 \\
61 & -1 & 47 & -1 & -1 & -1 & -1 & -1 & 55 & 25 & -1 & -1 & -1 & -1 & -1 & 0 & 0 & -1 & -1 & -1 & -1 & -1 & -1 & -1 & -1 & -1 & -1 & -1 & -1 & -1 & -1 & -1 & -1 & -1 \\
-1 & -1 & 39 & -1 & -1 & -1 & 84 & -1 & -1 & 41 & 72 & -1 & -1 & -1 & -1 & -1 & 0 & 0 & -1 & -1 & -1 & -1 & -1 & -1 & -1 & -1 & -1 & -1 & -1 & -1 & -1 & -1 & -1 & -1 \\
-1 & -1 & -1 & -1 & 46 & 40 & -1 & 82 & -1 & -1 & -1 & 79 & 0 & -1 & -1 & -1 & -1 & 0 & 0 & -1 & -1 & -1 & -1 & -1 & -1 & -1 & -1 & -1 & -1 & -1 & -1 & -1 & -1 & -1 \\
-1 & -1 & 95 & 53 & -1 & -1 & -1 & -1 & 14 & 18 & -1 & -1 & -1 & -1 & -1 & -1 & -1 & 0 & 0 & -1 & -1 & -1 & -1 & -1 & -1 & -1 & -1 & -1 & -1 & -1 & -1 & -1 & -1 & -1 \\
-1 & 11 & 79 & -1 & -1 & 2 & -1 & -1 & 47 & -1 & -1 & -1 & -1 & -1 & -1 & -1 & 0 & 0 & -1 & -1 & -1 & -1 & -1 & -1 & -1 & -1 & -1 & -1 & -1 & -1 & -1 & -1 & -1 & -1 \\
12 & -1 & -1 & -1 & 83 & 24 & -1 & 49 & -1 & -1 & -1 & 51 & -1 & -1 & -1 & -1 & -1 & -1 & 0 & 0 & -1 & -1 & -1 & -1 & -1 & -1 & -1 & -1 & -1 & -1 & -1 & -1 & -1 & -1 \\
-1 & -1 & -1 & -1 & -1 & 94 & -1 & 58 & -1 & -1 & 70 & 72 & -1 & -1 & -1 & -1 & -1 & -1 & -1 & 0 & 0 & -1 & -1 & -1 & -1 & -1 & -1 & -1 & -1 & -1 & -1 & -1 & -1 & -1 \\
-1 & -1 & 7 & 85 & -1 & -1 & -1 & 39 & 49 & -1 & -1 & -1 & -1 & -1 & -1 & -1 & -1 & -1 & -1 & 0 & 0 & -1 & -1 & -1 & -1 & -1 & -1 & -1 & -1 & -1 & -1 & -1 & -1 & -1 \\
43 & -1 & -1 & -1 & -1 & 66 & -1 & 41 & -1 & -1 & -1 & 26 & 7 & -1 & -1 & -1 & -1 & -1 & -1 & -1 & 0 & 0 & -1 & -1 & -1 & -1 & -1 & -1 & -1 & -1 & -1 & -1 & -1 & -1 \\
-1 & -1 & -1 & -1 & -1 & 17 & -1 & 9 & -1 & -1 & -1 & 20 & 0 & -1 & -1 & -1 & -1 & -1 & -1 & -1 & 0 & -1 & -1 & -1 & -1 & -1 & -1 & -1 & -1 & -1 & -1 & -1 & -1 & -1 \\
-1 & -1 & 36 & -1 & -1 & -1 & -1 & -1 & 7 & -1 & -1 & -1 & 0 & -1 & -1 & -1 & -1 & -1 & -1 & -1 & -1 & 0 & -1 & -1 & -1 & -1 & -1 & -1 & -1 & -1 & -1 & -1 & -1 & -1 \\
-1 & -1 & 5 & -1 & -1 & -1 & -1 & -1 & 5 & -1 & -1 & -1 & 0 & -1 & -1 & -1 & -1 & -1 & -1 & -1 & -1 & -1 & 0 & -1 & -1 & -1 & -1 & -1 & -1 & -1 & -1 & -1 & -1 & -1 \\
-1 & -1 & -1 & -1 & -1 & 23 & -1 & 11 & -1 & -1 & -1 & 29 & -1 & -1 & -1 & 0 & -1 & -1 & -1 & -1 & -1 & -1 & -1 & 0 & -1 & -1 & -1 & -1 & -1 & -1 & -1 & -1 & -1 & -1 \\
-1 & -1 & -1 & -1 & -1 & 5 & -1 & 32 & -1 & -1 & -1 & 38 & -1 & -1 & -1 & -1 & 0 & -1 & -1 & -1 & -1 & -1 & -1 & -1 & 0 & -1 & -1 & -1 & -1 & -1 & -1 & -1 & -1 & -1 \\
-1 & -1 & -7 & -1 & -1 & -1 & -1 & -1 & 19 & -1 & -1 & -1 & -1 & -1 & -1 & -1 & -1 & -1 & -1 & -1 & -1 & -1 & -1 & -1 & -1 & 0 & -1 & -1 & -1 & -1 & -1 & -1 & -1 & -1 \\
-1 & -1 & -1 & -1 & -1 & 31 & -1 & 28 & -1 & -1 & -1 & 48 & -1 & -1 & -1 & -1 & -1 & 0 & -1 & -1 & -1 & -1 & -1 & -1 & -1 & -1 & 0 & -1 & -1 & -1 & -1 & -1 & -1 & -1 \\
-1 & -1 & -1 & -1 & -1 & 29 & -1 & 87 & -1 & -1 & -1 & 7 & -1 & -1 & -1 & -1 & -1 & 0 & -1 & -1 & -1 & -1 & -1 & -1 & -1 & -1 & -1 & 0 & -1 & -1 & -1 & -1 & -1 & -1 \\
-1 & -1 & 6 & -1 & -1 & -1 & -1 & -1 & 3 & -1 & -1 & -1 & -1 & -1 & -1 & -1 & -1 & 0 & -1 & -1 & -1 & -1 & -1 & -1 & -1 & -1 & -1 & -1 & 0 & -1 & -1 & -1 & -1 & -1 \\
-1 & -1 & 1 & -1 & -1 & -1 & -1 & -1 & 2 & -1 & -1 & -1 & -1 & -1 & -1 & -1 & -1 & 0 & -1 & -1 & -1 & -1 & -1 & -1 & -1 & -1 & -1 & -1 & -1 & 0 & -1 & -1 & -1 & -1 \\
-1 & -1 & -1 & -1 & -1 & 37 & -1 & 26 & -1 & -1 & -1 & 8 & -1 & -1 & -1 & -1 & -1 & -1 & 0 & -1 & -1 & -1 & -1 & -1 & -1 & -1 & -1 & -1 & -1 & -1 & 0 & -1 \\
-1 & -1 & 3 & -1 & -1 & -1 & -1 & -1 & 8 & -1 & -1 & -1 & -1 & -1 & -1 & -1 & -1 & -1 & 0 & -1 & -1 & -1 & -1 & -1 & -1 & -1 & -1 & -1 & -1 & -1 & -1 & 0 \\
\end{bmatrix}
$$

$\cdots (13)$

The LDPC codes are not limited to the example shown here. Particularly, if the LDPC codes in which a difference between a large degree and a small degree is large in degree distribution and the distribution thereof is nonuniform are used, performance improvement effect can be easily manifested.

In the present embodiment, transfer is performed by sequentially allocating a bit of a larger column degree to a transmission line having a lower noise level (so that a bit of a larger column degree is allocated to the transmission line having a lower noise level), with respect to a difference in the noise level in each transmission line, which occurs when the MIMO technology is applied. Accordingly, a communication device having high decoding capability that improves the error correction capability can be realized.

Second Embodiment

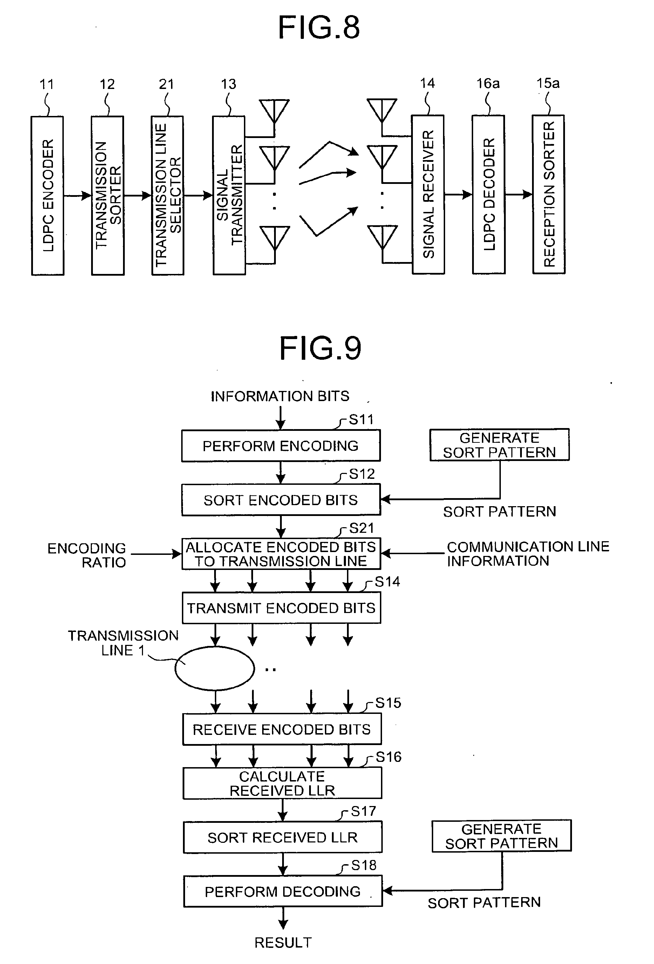

A communication device according to a second embodiment is explained next. Fig. 7 is a configuration example of the communication device according to the second embodiment. The communication device according to the present embodiment has a configuration such that a transmission line selector 21 is added to the transmitter included in the communication device according to the first embodiment. Because other parts are the same as the communication device according to the first embodiment, like reference numerals refer to like parts, and explanations thereof will be omitted. As in the communication device according to the first embodiment, in the communication device (receiver) according to the present embodiment, a part of the configuration can be replaced (see Fig. 8). The operation of the receiver in this case is as explained in the first embodiment.

The transmission line selector 21 corresponding to a transmission-line determining unit in claim 2 changes over whether to transmit an encoded bit sorted in the transmission sorter 12 sequentially to a transmission line having a lower noise level according to the encoding ratio, or to transmit the encoded bit alternately to a transmission line having a lower noise level and a transmission line having a higher noise level.

A signal transfer operation is explained. Fig. 9 is a flowchart showing one example of the operation of the communication device according to the second embodiment, where Step S21 is executed instead of Step S13 in the operation of the communication device according to the first embodiment (see Fig. 4). Because other steps are the same as in the first embodiment, like step numbers refer to like steps, and explanations thereof will be omitted. The operation is explained with reference to Fig. 9.

Subsequently after Step S12, the transmission line selector 21 in the transmitter selects whether to allocate an input signal (encoded bit) to a transmission line having a lower noise level in descending order of the column degree of the corresponding check matrix according to the encoding ratio, or to allocate the input signal alternately to a transmission line having a higher noise level and a transmission line having a lower noise level in descending order of the column degree. The signal transmitter 13 allocates the signal (encoded bit) to the transmission line according to the selection result of the transmission line selector 21 (Step S21), to transmit the signal (Step S14).

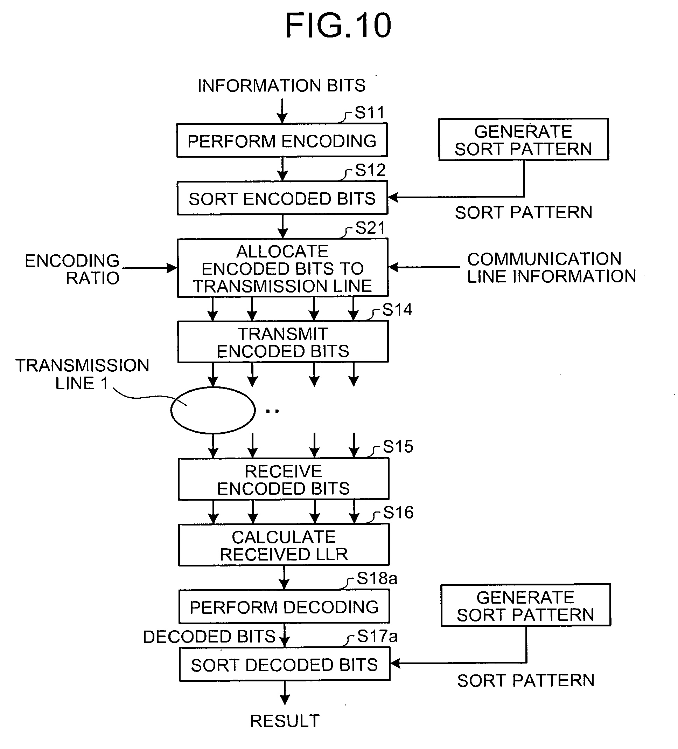

The flowchart showing the operation of the communication device including the receiver having the configuration shown in Fig. 8 is shown in Fig. 10. Also in this case, Step S21 is executed instead of Step S13 in the operation of the communication device (see Fig. 6) shown in Fig. 3 in the first embodiment.

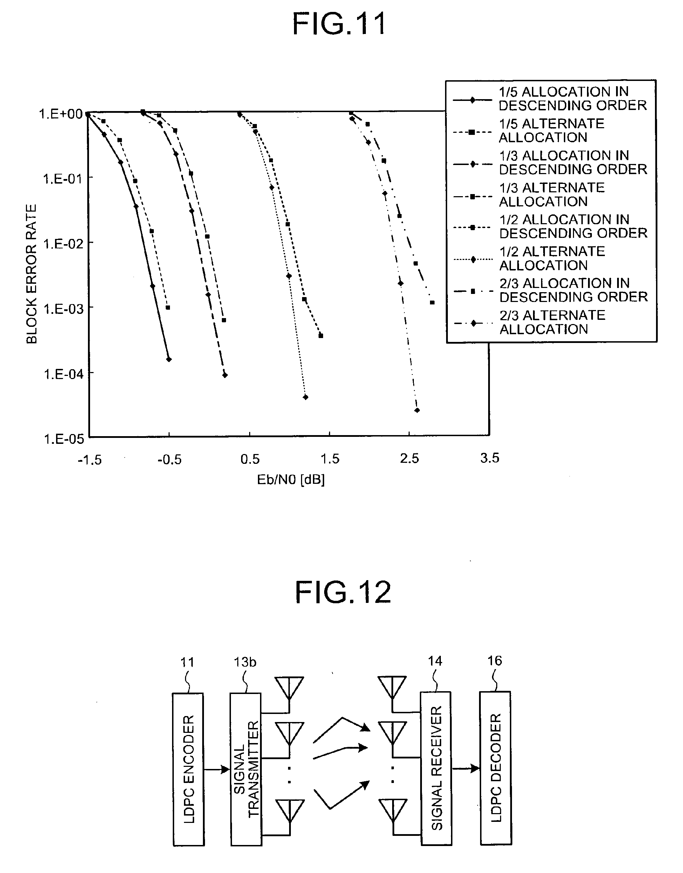

One example of the calculator simulation result of information transmission using the above procedure is shown in Fig. 11. Fig. 11 depicts calculator simulation results when the encoded bit of a higher column degree is allocated sequentially to a transmission line having a lower noise level and when the encoded bit of a higher column degree is allocated alternately to a transmission line having a lower noise level and a transmission line having a higher noise level, with respect to four transmission lines having a different noise level, by changing the encoding ratio. The four transmission lines correspond to a case that four transmitting antennas and four receiving antennas are used in the communication according to the MIMO technology. The condition for obtaining the calculator simulation result shown in Fig. 11 is such that the LDPC codes are generated according to the LDPC code generation procedure described in the first embodiment, the four transmission lines are additive white Gaussian communication lines having the information length of 1440 bits, in which the encoding ratio is 1/5, 1/3, 1/2, and 2/3, respectively, the modulation system is BPSK, the signal-to-noise ratio $Eb/N0$ is shifted from a mean value by (-4.5, -1.5, 1.5, and 4.5) [dB] respectively, the decoding method of the LDPC code is Sum-Product decoding method, and the number of repeat is 100 times.

In Fig. 11, the result obtained by allocating the encoded bit of a higher column degree to a transmission line having a lower noise level sequentially is referred to as "allocation in descending order", and the result obtained by allocating the encoded bit of a higher column degree alternately to a transmission line having a lower noise level and a transmission line having a higher noise level sequentially is referred to as "alternate allocation". A mean value of $Eb/N0$ of the four transmission lines (for example, if the four transmission lines are -4.2, -1.2, 1.8, and 4.8, respectively, the mean value is 0.3) is plotted on X axis, and the block error rate is plotted on Y axis. From the result shown in Fig. 11, it is seen that in the case of the encoding ratio of 1/5 and 1/3, the decoding performance is higher in the allocation in descending order; however, in the case of the encoding ratio of 1/2 and 2/3, the decoding performance is higher in the alternate allocation. Therefore, in this example, the transmission line selector 21 needs only to execute the changeover operation to select the allocation in descending order when the encoding ratio is 1/3 or lower, or the alternate allocation when the encoding ratio is 1/2 or higher.

In the present embodiment, transfer is performed by changing over a case that a bit of a larger column degree is allocated to a transmission line having a lower noise level according to the encoding ratio, and a case that the bit is allocated alternately to a transmission line having a lower noise level and a transmission line having a higher noise level, with respect to the difference in the noise level in each transmission line, which occurs when the MIMO technology is applied. Accordingly, a communication device having high decoding capability that improves the error correction capability can be realized.

Third Embodiment.
A communication device according to a third embodiment is explained next. Fig. 12 is a configuration example of the communication device according to the third embodiment. The transmitter included in the communication device according to the present embodiment has a configuration such that the transmission sorter 12 is deleted from the transmitter included in the communication device according to the first embodiment, and a signal transmitter 13b is included instead of the signal transmitter 13. The receiver has a configuration in which the reception sorter 15 is deleted from the receiver included in the communication device according to the first embodiment. Because other parts of the communication device are the same as the communication device according to the first embodiment, like reference numerals are denoted to like parts and explanations thereof will be omitted.

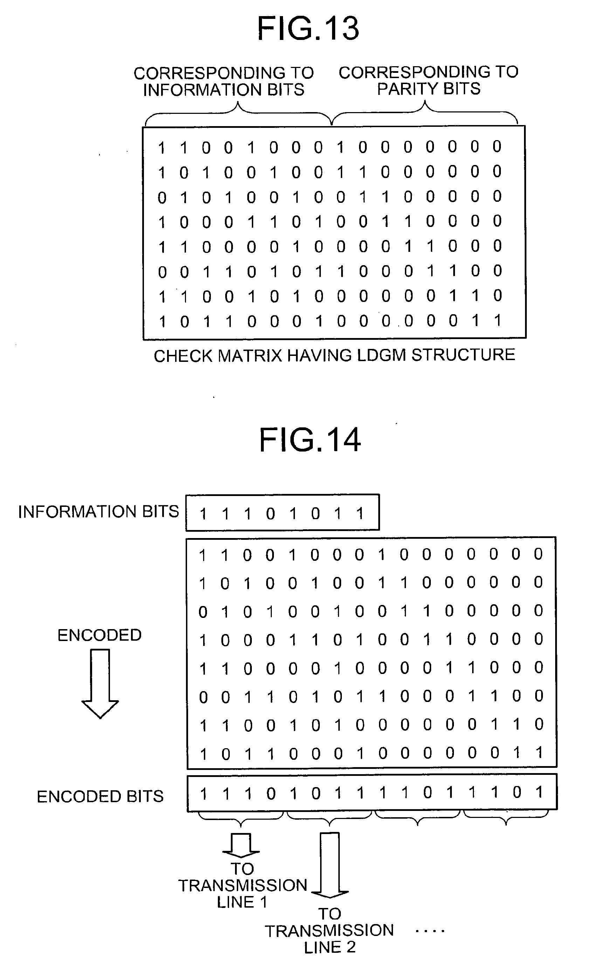

As shown in Fig. 13, in the LDPC codes (check matrix) having the LDGM structure, the column degree of the column corresponding to the parity bit is smaller than the column degree of the column corresponding to the information bit, and the column degree of the check matrix is mostly arranged sequentially from the head of the encoded bit. In the present embodiment, therefore, as shown in Fig. 14, the encoded bits are not sorted, and the encoded bits are allocated sequentially from the head of the bits corresponding to the information of the encoded bits to the transmission line having the lower noise level.

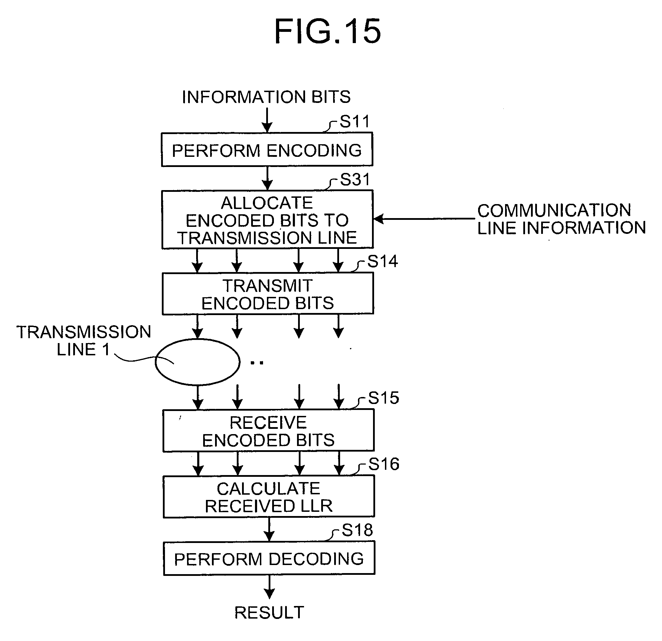

The signal transfer operation is explained. Fig. 15 is a flowchart of one example of the operation of the communication device according to the third embodiment, where Steps S12 and S17 are deleted from the operation of the communication device according to the first embodiment (see Fig. 4), and Step S31 is executed instead of Step S13. Because other steps are the same as in the first embodiment, like step numbers refer to like steps, and explanations thereof will be omitted. The operation is explained with reference to Fig. 15.

Subsequently after Step S12, the signal transmitter 13b in the transmitter allocates bits (information bits) corresponding to the information constituting the encoded bits from the head sequentially to the transmission line having good noise state (lower noise level) based on the noise state of the transmission line ascertained beforehand (Step S31), to transmit the signal (Step S14). The receiver calculates the received LLR and executes the decoding process without sorting the encoded bits.

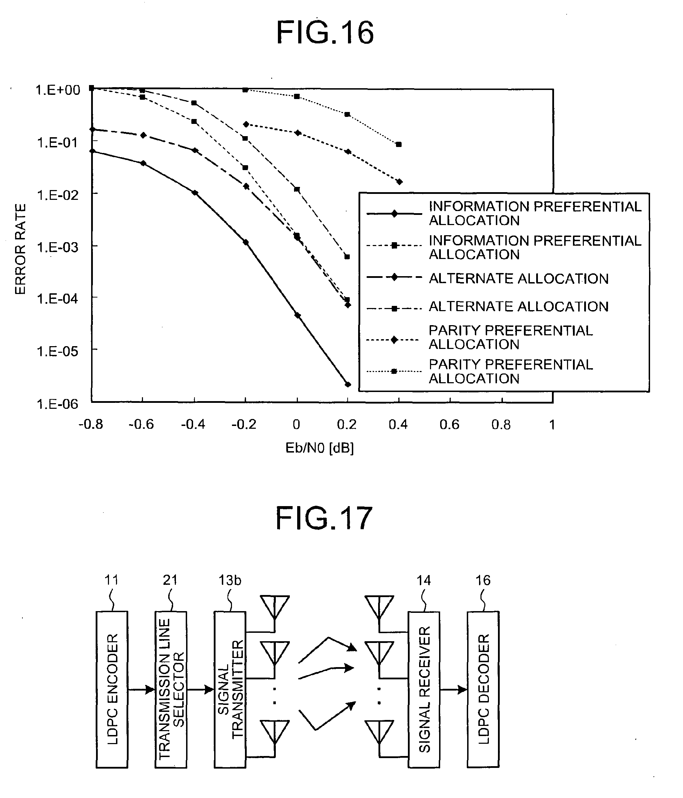

One example of the calculator simulation result of information transmission using the above procedure is shown in Fig. 16. Fig. 16 depicts calculator simulation results when the encoded bits are allocated from the head of the information bits sequentially to a transmission line having a lower noise level, with respect to four transmission lines having a different noise level. The four transmission lines correspond to a case that four transmitting antennas and four receiving antennas are used in the communication according to the MIMO technology. For comparison, Fig. 16 also depicts the simulation results of a case that a signal allocation order to the transmission line is reverse to the present embodiment (when bits are allocated sequentially from the parity bits to the transmission line having the lower noise level) and a case that the information bits and the parity bits are alternately allocated to each transmission line as an example of the transmission process, without taking the influence of the column degree into consideration.

The condition for obtaining the calculator simulation results shown in Fig. 16 is such that the LDPC codes are generated according to the LDPC code generation procedure described in the first embodiment, the four transmission lines are additive white Gaussian communication lines having the information length of 1440 bits and the encoding ratio of 1/3, in which the modulation system is BPSK, and the signal-to-noise ratio Eb/N0 is shifted from a mean value by (-4.5, -1.5, 1.5, and 4.5) [dB] respectively, the decoding method of the LDPC code is Sum-Product decoding method, and the number of repeat is 100 times. In Fig. 16, the result obtained by allocating the encoded bits from the head of the information bits sequentially to a transmission line having a lower noise level is referred to as "information preferential allocation", the result obtained by allocating the encoded bits from the parity bit sequentially to the transmission line having the lower noise level is referred to as parity preferential allocation", and the result obtained by allocating the information bits and the parity bits alternately to a transmission line having a lower noise level is referred to as "alternate allocation". A mean value of Eb/N0 of the four transmission lines (for example, if the four transmission lines are -4.2, -1.2, 1.8, and 4.8, respectively, the mean value is 0.3) is plotted on X axis, and the error rate is plotted on Y axis. From the result shown in Fig. 16, it is seen that the highest decoding performance can be obtained in the "information preferential allocation".

In the present embodiment, transfer is performed by allocating the encoded bits from the head of the information bits sequentially to the transmission line having a lower noise level, with respect to the difference in the noise level in each transmission line, which occurs when the MIMO technology is applied. Accordingly, in the case of the LDPC codes having the LDGM structure, the error correction capability can be improved as in the case that the encoded bits are sorted in order of higher column degree shown in the first embodiment. Further, sorting according to the column degree need not be performed for the transmitter and the receiver, thereby enabling to obtain the same effect as in the first embodiment with fewer processes.

Fourth Embodiment.

A communication device according to a fourth embodiment is explained next. Fig. 17 is a configuration example of the communication device according to the fourth embodiment of the present invention. The transmitter included in the communication device according to the present embodiment has a configuration in which the transmission line selector 21 is added to the transmitter included in the communication device according to the third embodiment. The transmission line selector 21 is the same as the transmission line selector 21 included in the communication device according to the second embodiment. Because other parts of the communication device are the same as the communication device according to the third embodiment, like reference numerals are denoted to like parts and explanations thereof will be omitted.

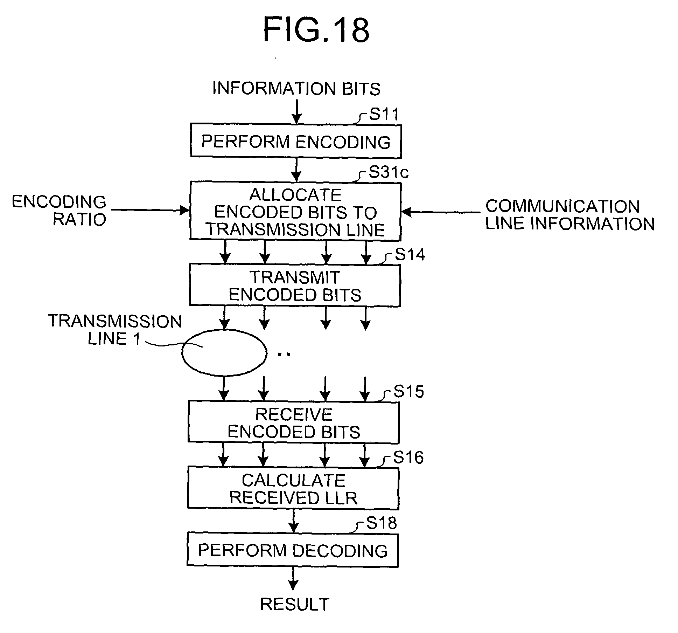

The signal transfer operation is explained. Fig. 18 is a flowchart of one example of the operation of the communication device according to the fourth embodiment, where Step S31c is executed instead of Step S31 in the operation of the communication device according to the third embodiment (see Fig. 15). Because other steps are the same as in the third embodiment, like step numbers refer to like steps, and explanations thereof will be omitted. The operation is explained with reference to Fig. 18.

Subsequently after Step S11, the transmission line selector 21 corresponding to the transmission-line determining unit in claim 4 ascertains beforehand the noise level of the transmission line, and changes over whether to allocate an encoded bit from the head of the information bits sequentially to a transmission line having a lower noise level according to the encoding ratio of the input signal (encoded bit), or to allocate the encoded bit from the head of the information bits alternately to a transmission line having a lower noise level and a transmission line having a higher noise level. The signal transmitter 13 allocates the signal (encoded bit) to the transmission line according to the selection result by the transmission line selector 21 (Step S31c), and transmits the encoded bit (Step S14).

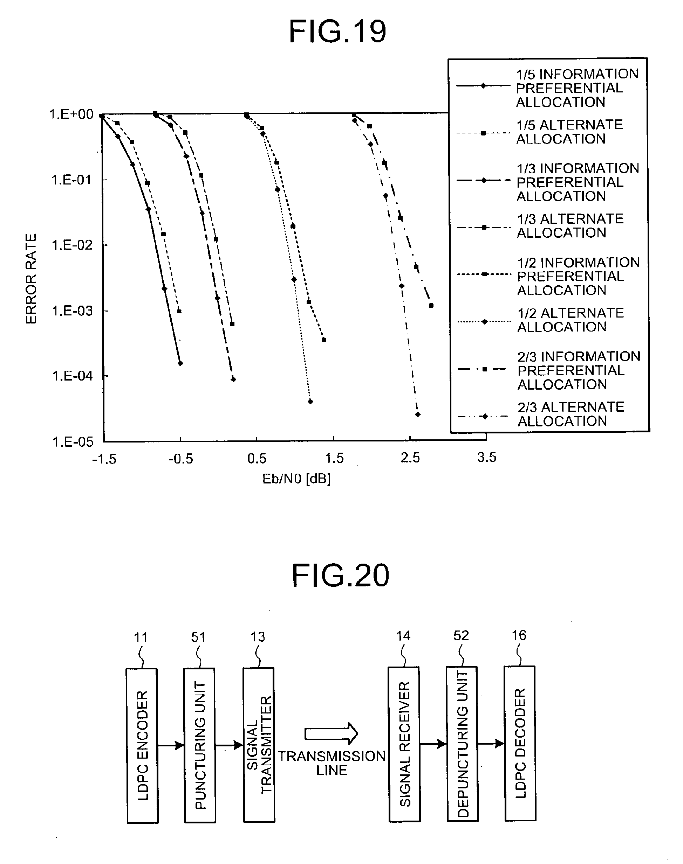

One example of the calculator simulation result of information transmission using the above procedure is shown in Fig. 19. Fig. 19 depicts calculator simulation results when the encoded bit of a higher column degree is allocated sequentially to a transmission line having a lower noise level (condition 1), and when the encoded bits are allocated alternately to a transmission line having a lower noise level and a transmission line having a higher noise level (condition 2), with respect to four transmission lines having a different noise level, by changing the encoding ratio. The four transmission lines correspond to a case that four transmitting antennas and four receiving antennas are used in the communication according to the MIMO technology. The condition for obtaining the calculator simulation results shown in Fig. 19 is such that the LDPC codes are generated according to the LDPC code generation procedure described in the first embodiment, the four transmission lines are additive white Gaussian communication lines having the information length of 1440 bits, in which the encoding ratio is either one of 1/5, 1/3, 1/2, and 2/3, the modulation system is BPSK, the signal-to-noise ratio Eb/N0 is shifted from a mean value by (-4.5, -1.5, 1.5, and 4.5) [dB] respectively, the decoding method of the LDPC code is Sum-Product decoding method, and the number of repeat is 100 times.

In Fig. 19, the calculator simulation result in the case of condition 1 is denoted by "information preferential allocation", and the calculator simulation result in the case of condition 2 is denoted by "alternate allocation". A mean value of Eb/N0 of the four transmission lines (for example, if the four transmission lines are -4.2, -1.2, 1.8, and 4.8, respectively, the mean value is 0.3) is plotted on X axis, and the error rate is plotted on Y axis. From the result shown in Fig. 19, it is seen that in the case of the encoding ratio of 1/5 and 1/3, the decoding performance is high when the information preferential allocation is performed (in the case of condition 1); however, in the case of the encoding ratio of 1/2 and 2/3, the decoding performance is high in the alternate allocation (in the case of condition 2). Therefore, in this example, the transmission line selector 21 needs only to execute the changeover operation to select the information preferential allocation when the encoding ratio is 1/3 or lower, or the alternate allocation when the encoding ratio is 1/2 or higher.

In the present embodiment, transfer is performed by changing over a case that the encoded bits are allocated from the head of the information bits sequentially to a transmission line having a lower noise level according to the encoding ratio, and a case that the encoded bits are allocated alternately to a transmission line having a lower noise level and a transmission line having a higher noise level, with respect to the difference in the noise level in each transmission line, which occurs when the MIMO technology is applied. Accordingly, in the case of the LDPC codes having the LDGM structure, the error correction capability can be further improved as compared to the third embodiment. Further, sorting according to the column degree need not be performed for the transmitter and the receiver, thereby enabling to suppress an increase of processes.

Fifth Embodiment.

A communication device according to a fifth embodiment is explained next. Fig. 20 is a configuration example of the communication device according to the fifth embodiment according to the present invention. The transmitter included in the communication device according to the present embodiment has such a configuration that the transmitter in the communication device according to the first embodiment includes a puncturing unit 51 instead of the transmission sorter 12, and the receiver includes a depuncturing unit 52 instead of the reception sorter 15. Because other parts of the communication device are the same as the communication device according to the first embodiment, like reference numerals are denoted to like parts and explanations thereof will be omitted.

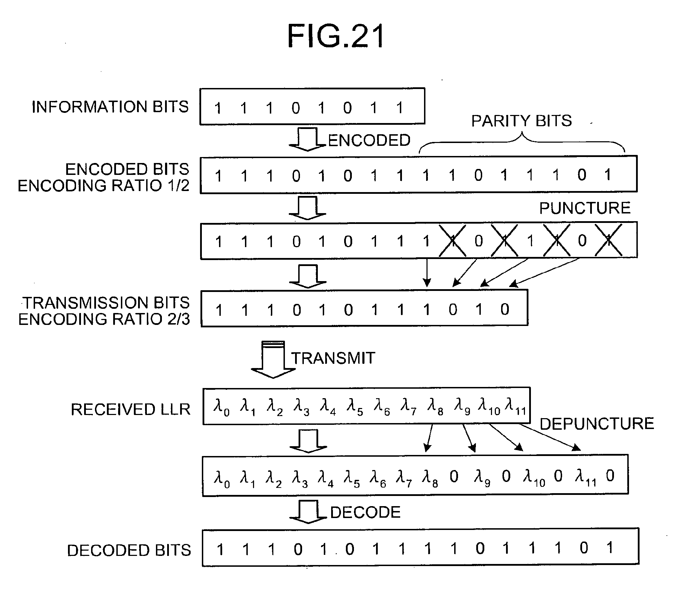

A puncturing operation performed by the communication device on the transmission side (transmitter) and a depuncturing operation performed by the communication device on the reception side (receiver) are explained with reference to Fig. 21. Fig. 21 is one example of the puncturing process and the depuncturing process.

The LDPC encoder 11 encodes the input transmission information with the encoding ratio of 1/2, and transmits all the encoded bits to the puncturing unit 51. The puncturing unit 51 punctures the parity bits included in the encoded bits according to a procedure shown in Fig. 21, so that the received encoded bits have an encoded bit length required by the communication system, to adjust the encoding ratio, to thereby generate transmission bits having the encoding ratio of 2/3.

The depuncturing unit depunctures the signal received from the signal receiver 14 (received bits) according to the procedure shown in Fig. 21. Specifically, the depuncturing unit inserts 0 (dummy bit) indicating that there is no reliability information as the LLR of the bit punctured in the transmitter into a position of the bit punctured in the transmitter, to perform depuncturing so that respective received bits return to the original positions (return to the positions before being punctured in the transmitter), and transmits the result thereof to the LDPC decoder 16.

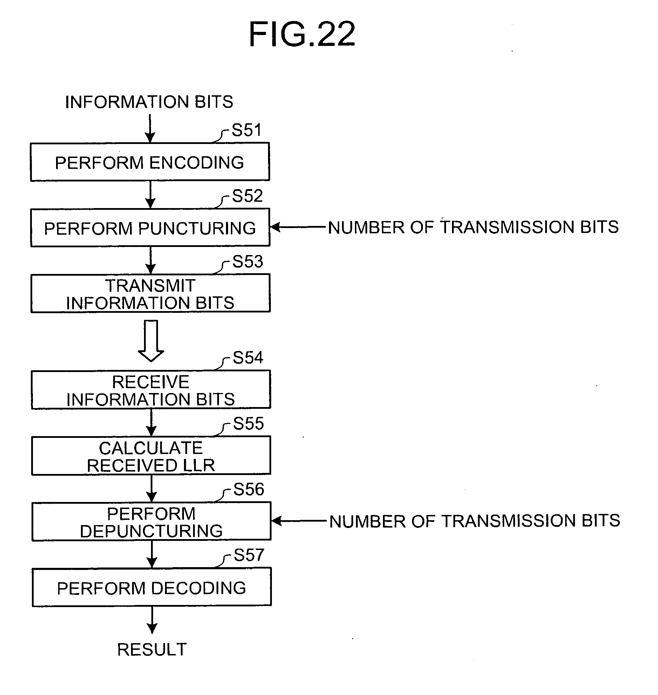

The signal transfer operation is explained. Fig. 22 is a flowchart showing one example of the operation of the communication device according to the fifth embodiment. The operation is explained with reference to Fig. 22.

The LDPC encoder 11 in the communication device on the transmission side (transmitter) encodes the transmission information with the encoding ratio of 1/2 (Step S51). The puncturing unit 51 then punctures the parity bits in the codes generated by the LDPC encoder 11 (Step S52), so that the encoded bit length required by the communication system can be obtained. A specific puncturing procedure is shown below. In the puncturing procedure below, k denotes the number of information bits, n denotes a length of encoded bit required by the system, and the size of q is changed as a power of two, according to the maximum encoding ratio. Because it is assumed here that the code having the encoding ratio of 1/2 is punctured, the parity bit length is the same as the information bit length.

The puncturing unit 51 determines the number of division s of the parity bits by using following equation (14).

$$s=[k/q] \qquad \ldots (14)$$

Parity bit number $r_{i,j}$ calculated according to following equation (15) is then allocated to the divided blocks. Equation (15) indicates that the first parity bit is allocated to the jth bit of the ith block.

$$r_{i,j}=1, \quad (i=1/q, \ j=l \bmod q) \qquad \ldots (15)$$

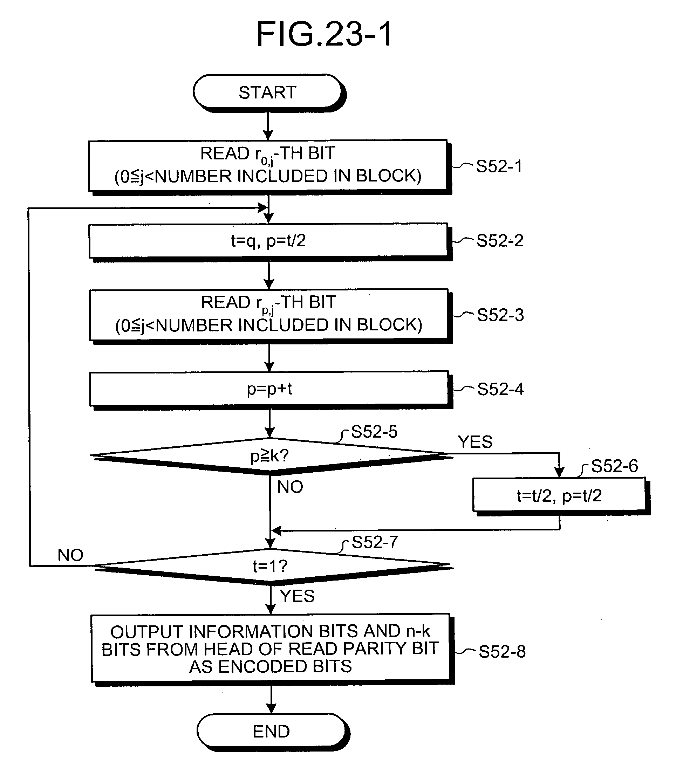

The puncturing unit 51 executes an operation according to Fig. 23-1, which is a flowchart showing one example of the puncturing process, and outputs punctured encoded bits. Specifically, the puncturing unit 51 first reads the $r_{0,j}$ ($0 \leq j <$number included in the block)th bit (Step S52-1). The puncturing unit 51 then sets as t=q, p=t/2 (Step S52-2) and reads the $r_{p,j}$ ($0 \leq j <$number included in the block)th bit (Step S52-3).

The puncturing unit 51 sets as p=p+t (Step S52-4) and confirms the state of p (Step S52-5). If p≥k (YES at Step S52-2), the puncturing unit 51 sets as t=t/2, p=t/2 (Step S52-6), to confirm if t=1 (Step S52-7). On the other hand, if p<k (NO at Step S52-2), the puncturing unit 51 immediately confirms the state of p (Step S52-5). If t=1 (YES at Step S52-7), the puncturing unit 51 outputs the information bits and n-k bits from the head of the read parity bits as the encoded bits (in total, n bits) (Step S52-8). On the other hand, if t≠1 (NO at Step S52-7), the puncturing unit 51 proceeds to Step S52-3 (Step S52-5). Hereinafter, a parity bit string immediately after encoding is referred to as an encoded parity bit string, and the parity bit string after being punctured is referred to as a send sequence parity bit string.

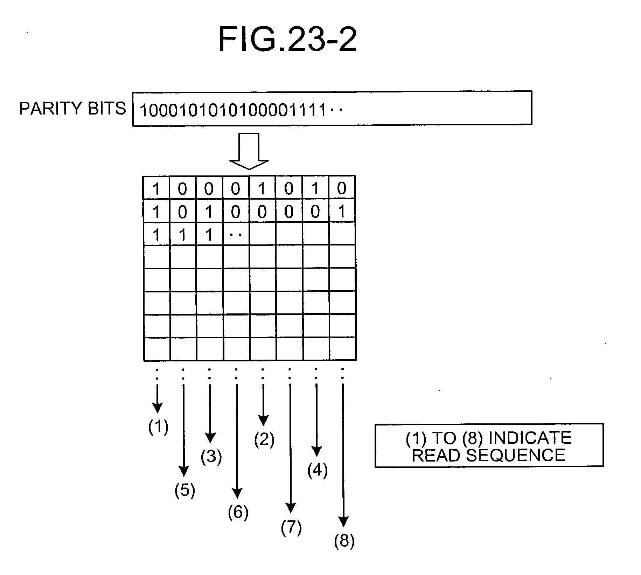

Fig. 23-2 is one example of bit replacement by the puncturing process (process shown in Fig. 23-1). As shown in Fig. 23-2, the puncturing unit 51 prepares q storage destinations of the encoded parity bit string, and stores the encoded parity bit string sequentially from the head. The puncturing unit 51 then reads all the bits in the 0th storage destination, all the bits in the q/2nd storage destination, all the bits in the q/4th storage destination, and then all the bits in order of the 3q/4th, the q/8th, the 3q/8th, 5q/8th, 7q/8th ... storage destinations, to obtain the send sequence parity bit string. In Fig. 23-2, circled numerals 1 to 8 indicate read sequence of the bits. When the send sequence parity bit string is obtained, the puncturing unit 51 sends n bits obtained by combining the k-bit information bit string and the send sequence parity bit string to the signal transmitter 13. The signal transmitter 13 transmits the received information bit string and the send sequence parity bit string to the communication device on the reception side (Step S53).

When the signal receiver 14 in the communication device on the reception side (receiver) receives the signal (Step S54), and calculates the received LLR (Step S55), the depuncturing unit 52 performs processing reverse to the processing performed by the puncturing unit 51 (processes shown in equation (14) and equation (15) and the process shown in Fig. 23-1), to return the received LLR to the bit position immediately after encoding (perform depuncturing) as shown in Fig. 21, and sends the received LLR to the decoder (Step S56). At this time, the bits not transferred due to puncturing are sent to the decoder, by setting the LLR as 0 due to no reliability information. The depuncturing unit 52 obtains beforehand information relating to the puncturing process performed on the transmission side, to perform depuncturing based on the information. The LDPC decoder 16 performs decoding based on the received LLR, and outputs a decoding result (Step S57).

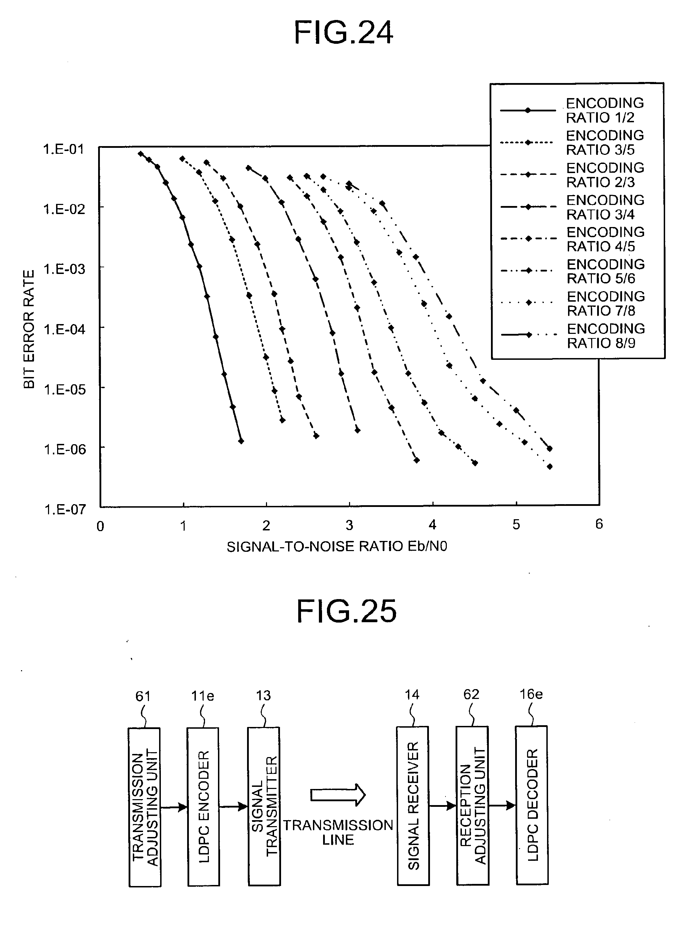

When IR is to be performed, the send sequence parity bits are output sequentially from the head of the untransmitted bits. One example of the calculator simulation result of information transmission using the above procedure is shown in Fig. 24. The condition for obtaining the calculator simulation results shown in Fig. 24 is such that the additive white Gaussian communication line is used, the LDPC code with encoding ratio of 1/2 as a reference is generated according to the LDPC code generation procedure described in the first embodiment, the information length is 1440 bits, the encoding ratio after puncturing is either one of 1/2 (in this case, no puncturing), 3/5, 2/3, 3/4, 4/5, 5/6, 7/8, and 8/9, and the modulation system is BPSK. The decoding method of the LDPC code is Sum-Product decoding method, and the number of repeat is 100 times. It is understood from the result shown in Fig. 24 that setting of the encoding ratio in unit of bit and IR are possible in the present embodiment, and any encoding ratio shows the decoding performance close to the Shannon limit.

In the present embodiment, the LDPC code with the encoding ratio being 1/2 is used as a reference code, and when the encoding ratio is "power of two/(power of two+1)", the bit position to be punctured is determined by using the above procedure so that the positions not punctured are at regular intervals, and in cases of other encoding ratios, the parity bits are punctured sequentially from the end to obtain the required encoding ratio, based on a case that the encoding ratio is smaller than the relevant encoding ratio and closest thereto (corresponding to "power of two/(power of two+1)"). As a result, the encoding ratio can be flexibly adjusted according to system requirement, while suppressing deterioration of the decoding capability.

An example in which when the encoding ratio is "power of two/(power of two+1)", the bit positions not to be punctured are determined to be at regular intervals, and in cases of other encoding ratios, the parity bits are punctured sequentially from the end to obtain the required encoding ratio, based on the case that the encoding ratio is smaller than the relevant encoding ratio and closest thereto (corresponding to "power of two/(power of two+1)") is explained here. However, in the communication system, when an encoding ratio (corresponding to "(power of two-1)/power of two") is required more than the encoding ratio (corresponding to "power of two/(power of two+1)"), the puncture position can be determined so that the positions are at regular intervals with the encoding ratio (corresponding to "(power of two-1)/power of two"). Further, when the puncture positions are determined with an encoding ratio other than the reference encoding ratio with regular intervals, the positions can be determined in an arbitrary order, not from the end.

Sixth Embodiment.
A communication device according to a sixth embodiment is explained next. Fig. 25 is a configuration example of the communication device according to the sixth embodiment. The transmitter included in the communication device according to the present embodiment includes a transmission adjusting unit 61, an LDPC encoder 11e, and the signal transmitter 13. The receiver includes the signal receiver 14, a reception adjusting unit 62, and an LDPC decoder 16e. The signal transmitter 13 and the signal receiver 14 are the same as those included in the communication device according to the first embodiment.

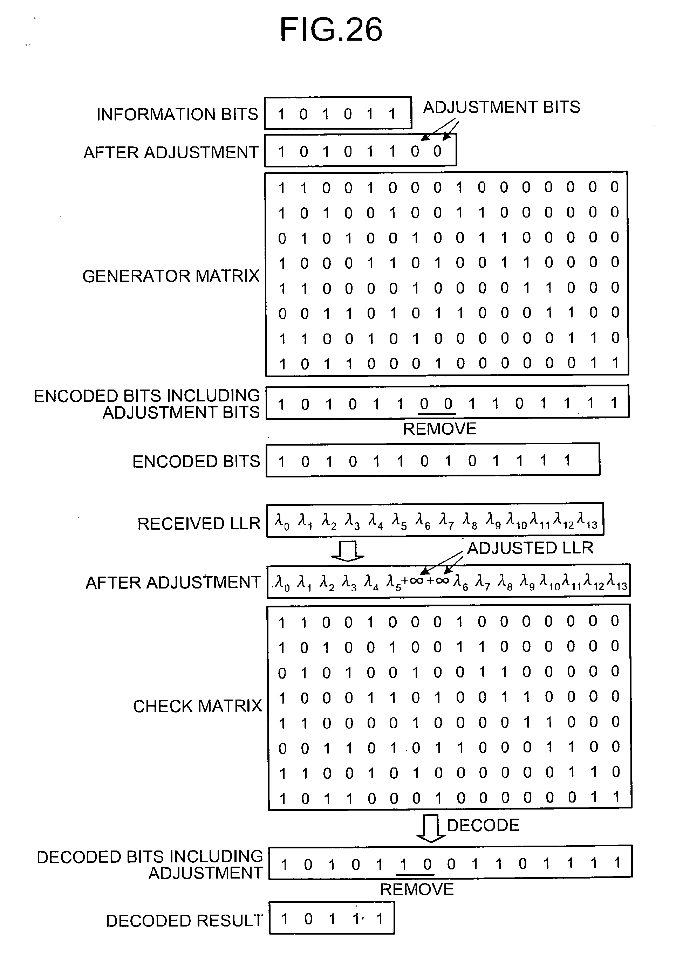

The operation of respective units in the communication device and the signal transfer operation are briefly explained with reference to Fig. 25 and Fig. 26. Fig. 26 is one example of the operation performed by the communication device according to the sixth embodiment for signal transfer.

The transmission adjusting unit 61 corresponding to a bit-length adjusting unit in claim 7 inserts an adjustment bit to the information bits (transmission information), when an information bit length required by the system (bit length of the information to be transmitted) does not match the size of the generator matrix prepared for generating the LDPC codes, and sends the information bits to the LDPC encoder 11e. The LDPC codes here can be encoded when "(number of columns) - (number of rows)" in the generator matrix matches the information bit length. However, the information bit length required by the system can be shorter than the length of transmission information determined by the check matrix. In such a case, the transmission adjusting unit 61 adjusts the number of bits, as shown in Fig. 26, by inserting 0 to the head or the end of the transmission information by the insufficient number of bits, and outputs the adjusted transmission information to the LDPC encoder 11e.

The LDPC encoder 11e executes the same process as that of the LDPC encoder 11 according to the first embodiment, to perform LDPC encoding (generation of the encoded bits) with respect to the transmission information including the adjustment bit. The LDPC encoder 11e then outputs the encoded bits after the adjustment bit is removed from the generated encoded bits to the signal transmitter 13. This process can be performed not only for the LDPC codes, which require the generator matrix separately from the check matrix, but also for the LDPC codes having the LDGM structure in which the check matrix and the generator matrix are commonly used.

The reception adjusting unit 62 inserts an adjustment bit (dummy bit) to the received LLR received from the signal receiver 14, when the information bit length required by the system does not match the size of the prepared check matrix, and sends the received LLR to the LDPC decoder 16e. The LDPC decoder 16e performs decoding based on the received LLR. For the LLR corresponding to 0 inserted by the transmission adjusting unit 61, a value set by using a positive value as large as possible as an adjustment LLR is input to perform decoding (see Fig. 26). In this example, 0 is inserted as the adjustment bit, however, 1 can be inserted. In this case, the reception adjusting unit sets a negative value as small as possible as the adjustment LLR, to perform decoding.

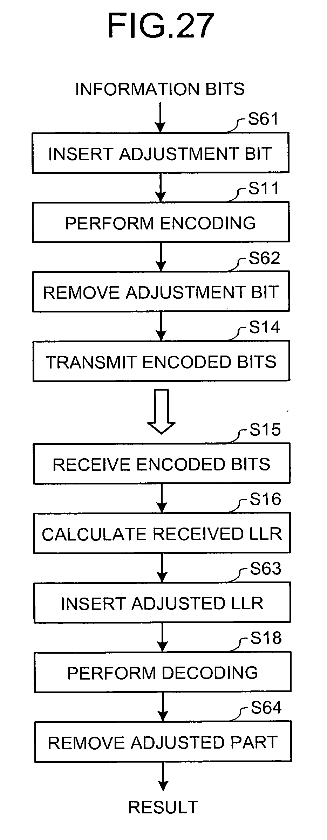

The signal transfer operation is explained next in detail. Fig. 27 is a flowchart showing one example of the operation of the communication device according to the sixth embodiment, and the operation is explained with reference to Fig. 27. Like step numbers refer to like process as in the operation of the communication device according to the first embodiment (see Fig. 4). A process different from that of the first embodiment is mainly explained.

In the communication device on the transmission side (receiver), the transmission adjusting unit 61 compares the information bit length k required by the system with the size of the generator matrix (nxm matrix), and inserts the adjustment bit as required (Step S61). Specifically, the transmission adjusting unit 61 calculates insufficient number of bits g (=n-m-k), to insert 0 or 1 for the g bits at the head or at the end of the transmission information series. The LDPC encoder 11e encodes the series of n-m bits including the inserted bit (Step S11), and outputs k information bits and n-k parity bits (Step S62).

In the communication device on the reception side (receiver), after the signal receiver 14 executes the reception process and the received LLR calculation process (Steps S15 and S16), the reception adjusting unit 62 calculates the number of bits inserted at the time of encoding based on the check matrix and the information bit length required by the system. When the inserted bit is 0, the reception adjusting unit 62 inserts a positive value sufficiently large (which does not affect the decoding performance) in the received LLR as the adjustment LLR, which is then sent to the LDPC decoder 16e. On the other hand, if the inserted bit is 1, the reception adjusting unit 62 inserts a negative value sufficiently small in the received LLR as the adjustment LLR, which is then sent to the LDPC decoder 16e (Step S63). The LDPC decoder 16e performs decoding based on the received LLR received from the reception adjusting unit 62, and outputs a decoding result in which the adjustment bit is removed (Step S64). It can be specified beforehand as the communication system whether to insert 0 or 1 as the bit to be inserted.

When the number of insertion of the adjustment bits is large, the decoding performance can change considerably depending on the insertion positions. That is, the decoding performance of the LDPC code largely depends on the degree distribution. Therefore, to suppress deterioration of the decoding performance, a position where the influence on the performance is small can be predetermined as the insertion position of the adjustment bit. For example, in the case of the check matrix generated in the LDPC code generation procedure explained in the first embodiment, the bit at the end has many bits of the same degree, and the bit at the head has fewer bits of the same degree. Therefore, the influence on the degree distribution becomes smaller by inserting the adjustment bit at the end than inserting the adjustment bit at the head, thereby enabling to maintain high decoding performance. Thus, by using the characteristic of the degree distribution to determine the insertion position of the adjustment bit to be at the head, at the end, or in the middle of the information bits, the error correction capability can be improved.

In the present embodiment, when the size of the LDPC codes and the information bit length required by the system are different, the transmitter inserts 0 or 1 by the number predetermined for the insufficient number of bits to adjust the information bits, and executes the encoding process. On the other hand, the receiver inserts the LLD for adjustment to the received LLR and executes the decoding process. Accordingly, even when the size of the LDPC codes and the information bit length required by the system are different, the transmission information can be encoded to the LDPC codes and transmitted.

Seventh Embodiment.

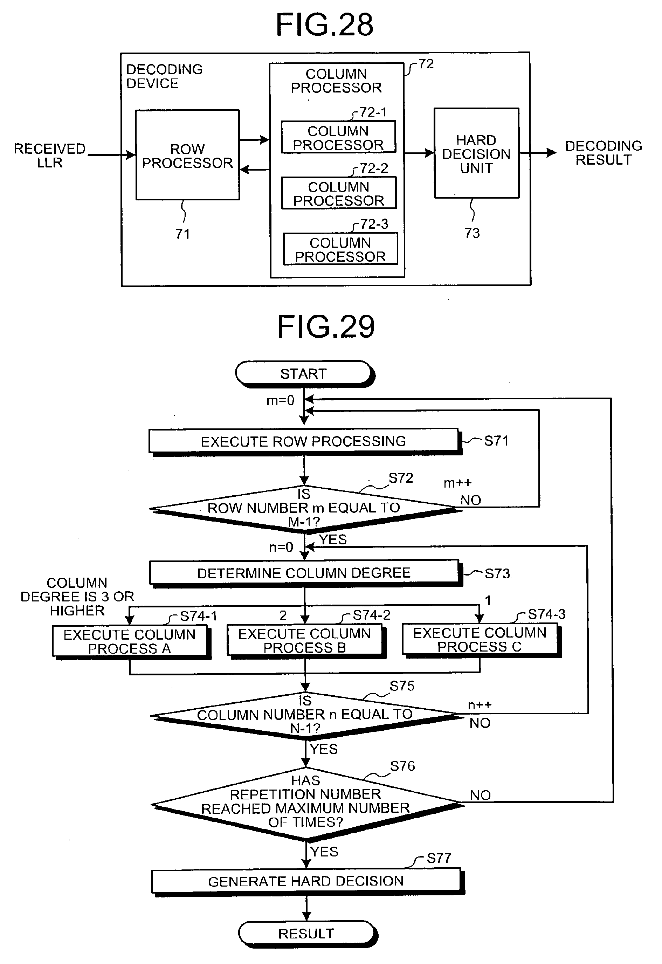

A communication device according to a seventh embodiment is explained next. Fig. 28 is a configuration example of the decoding device included in the communication device according to the seventh embodiment. The decoding device constitutes the LDPC decoder included in any communication device explained in the first to sixth embodiments, and includes a row processor 71 that performs row processing relating to decoding of the LDPC codes, a column processor 72 that performs column processing relating to decoding of the LDPC codes, and a hard decision unit 73 that performs hard decision for obtaining a decoding result. The column processor 72 includes a column processor 72-1 that performs normal column processing, a column processor 72-2 that performs column processing for column degree 2, and a column processor 72-3 that performs column processing for column degree 1. In the present embodiment, a case that the most common Sum-Product decoding method is used as the decoding method of the LDPC code is explained. However, the seventh embodiment is also applicable to a case that other LDPC code decoding methods are used. The decoding device according to the present embodiment corresponds to a repetition decoder.

To express the decoding process of the LDPC codes, signs relating to the LDPC codes are defined below.

The check matrix of the LDPC codes is defined as "$H=[H_{m,n}]$, ($0 \leq n < N$, $0 \leq m < M$)]. In a check node m, a set of bit nodes having 1 is defined as "$N(m)=\{n:H_{m,n}=1\}$", and in a check node n, a set of bit nodes having 1 is defined as "$M(n)=\{m:H_{m,n}=1\}$". "$N(m)\backslash n$" indicates a set excluding n, and "$M(n)\backslash m$" indicates a set excluding m. Further, $w'=[w'_n]$ is defined as a decoding series, and $F_n$ is defined as an LLR of a received value.

In a Sum-Product algorithm, "$e_{m,n}^{(i)}$, which is an LLR of bit n to be sent from check node m to bit node n", "$Z_{m,n}^{(i)}$, which is an LLR of bit n to be sent from bit node n to check node m", and $Z_n^{(i)}$, which is a posterior value of bit n" are updated. An initial value to perform decoding is then set to $Z_{m,n}^{(0)}=F_n$.

The decoding process by the decoding device according to the seventh embodiment is explained below.

In the decoding device shown in Fig. 28, the row processor 71 performs a process shown in following equation (16).

[Numerical Expression 11]

$$\tau_{m,n}(i) = \prod_{n' \in N(m)\backslash n} \tanh(z_{m,n'}(i-1)/2)$$

$$\varepsilon_{m,n}(i) = \log \frac{1 + \tau_{m,n}(i)}{1 - \tau_{m,n}(i)} \qquad \ldots(16)$$

In the column processor 72, when a column corresponding to the information bit is to be processed with respect to ($0 \leq n < N$, $m \in M(n)$), the column processor 72-1 executes a process shown in following equation (17) (hereinafter, column process A). When a column corresponding to the parity bit and having the column degree of 2 is to be processed, the column processor 72-2 executes a process shown in following equation (18) (hereinafter, column process B). When a column corresponding to the parity bit and having the column degree of 1 is to be processed, the column processor 72-3 executes a process shown in following equation (19) (hereinafter, column process C).

[Numerical Expression 12]

$$z_n(i) = F_n + \sum_{m' \in M(n)} \varepsilon_{m,n}(i)$$

$$z_{m,n}(i) = z_n(i) - \varepsilon_{m,n}(i) \qquad \ldots(17)$$

$$Z_{m,n}^{(i)} = F_n + e_{m,n'}^{(i)}$$

$$Z_{m,n'}^{(i)} = F_n + e_{m,n}^{(i)} \qquad \qquad \dots (18)$$

$$Z_{m,n}^{(i)} = F_n \qquad \qquad \dots (19)$$

The hard decision unit 73 performs hard decision with respect to $Z_n^{(i)}(0 \leq n < k)$, to generate a decoding series $w' = [w'_n]$. That is, if $Z_n^{(i)}$ is positive, it is determined that $w'_n$ is 0, if $Z_n^{(i)}$ is negative, it is determined that $w'_n$ is 1, and the result is output as a decoding result.

The operation of the decoding device according to the present embodiment is explained next. Fig. 29 is a flowchart showing one example of the operation of the decoding device according to the seventh embodiment. The operation is explained with reference to Fig. 29.

The row processor 71 executes the row processing (see above equation (16)) with respect to the received LLR for predetermined number of times (M times) to obtain $e_{m,n}^{(i)}$ (Steps S71 and S72). When $e_{m,n}^{(i)}$ is input from the row processor 71, the column processor 72 determines the column degree (confirms n value) to select the process to be executed with respect to the input signal (Step S73). As a result of column degree determination at Step S73, in the case of the process of a column corresponding to the information bit (the column degree is 3 or higher), the column processor 72-1 executes the column process A (Step S74-1). In the case of a column corresponding to the parity bit and having the column degree of 2, the column processor 72-2 executes the column process B (Step S74-2). In the case of a column corresponding to the parity bit and having the column degree of 1, the column processor 72-3 executes the column process C (Step S74-3). Thereafter, the column processor 72 executes the column processing (any one of Steps S74-1 to S74-3) for predetermined number of times (N times) to obtain $Z_{m,n}^{(i)}$ (Steps S73, S74-1 to 74-3, and S75). Further, the row processor 71 and the column processor 72 repetitively execute the row processing and the column processing until reaching the maximum number of times, and at a point in time of finishing the repetition, the column processor 72 outputs $Z_{m,n}^{(i)}$ as $Z_n^{(i)}$ to the hard decision unit 73 (YES at Step S76). When $Z_n^{(i)}$ is input from the column processor 72, the hard decision unit 73 generates decoding bits and outputs it (Step S77). The decoding bits generated here are only the bits corresponding to the information bits.

In the decoding algorithm of the LDPC codes conventionally used, the hard decision is performed every time the row processing and the column processing are executed, and after the decoding results of not only the information bits but also the parity bits are obtained, the parity check is performed. As a result of the parity check, if all the checks are satisfied, it is determined that decoding is complete to finish repetition of the row processing and the column processing. However, when the decoding algorithm is actually installed and used in the receiver or the like, the decoding process needs only to be finished within specified delay time, and the decoding process need not always be finished in the middle of the processing. In the operation of the present embodiment, therefore, the parity check is not performed under condition that there is enough processing time with respect to the specified delay time. Accordingly, the hard decision of the parity bits, the arithmetic operation of $Z_n^{(i)}$, and the number of addition (adding processing) when the column degree is small can be decreased.

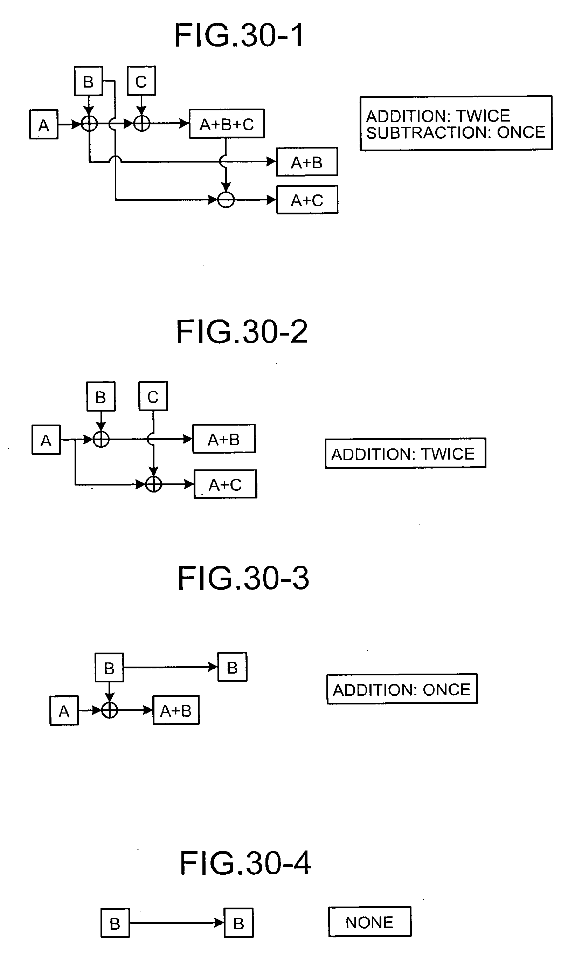

For example, as shown in Fig. 30-1 to Fig. 30-4, when the column degree is 2 or 1, by changing over the processing, the amount of calculation can be reduced than executing all column processing with the same configuration. That is, in the present embodiment, when the column degree is 2 or 1, the processing is changed over, thereby enabling to reduce the number of addition. In the above example, a case that the Sum-Product decoding method is used has been explained. However, the same reduction effect can be obtained with respect to the decoding methods of the LDPC codes, in which the similar arithmetic operation is performed in the column processing.

Fig. 30-1 is a processing example when the column degree is 2 and the column process A is used, and Fig. 30-2 is a processing example when the column degree is 2 and the column process B is used. Further, Fig. 30-3 is a processing example when the column degree is 1 and the column process A is used, and Fig. 30-4 is a processing example when the column degree is 1 and the column process C is used.

Eighth Embodiment.

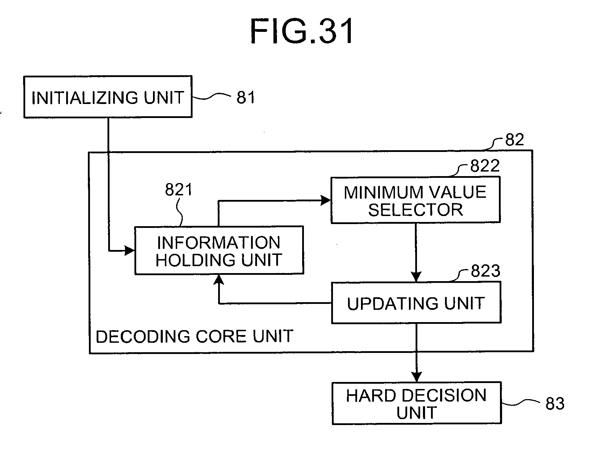

An eighth embodiment is explained next. Fig. 31 is a configuration example of a decoding device according to the eighth embodiment of the present invention. The decoding device according to the present embodiment includes an initializing unit 81 that initializes the decoding process, a decoding core unit 82 that updates the reliability information relating to decoding of the LDPC codes, and a hard decision unit 83 that performs hard decision for obtaining a decoding result and determines discontinuance standard of repetition decoding. The decoding core unit 82 includes, as a partial configuration, a minimum value selector 821 that selects three minimum values, an updating unit 822 that calculates new reliability and updates the reliability, and an information holding unit 823 that holds update information.

The algorithm installed in the decoding device according to the eighth embodiment is shown below. Respective signs for expressing decoding of the LDPC codes are the same as those in the seventh embodiment.

As the initialization process, $e_{m,n}^{(0)} = 0$ is set for $m \in \{1, ..., M\}$ and $n \in N(m)$, and $Z_n^{(0)} = F_n$ is set for $n \in \{1, ..., N\}$.

As Step 1 (update of reliability information), following process is performed.

[Step 1-1]

Following equation (20) is calculated for $n \in N(m)$, regarding each m in $1 \le m \le M$.

$$Z_{m,n}^{(1-1)} = Z_n^{(1-1)} - e_{m,n}^{(1-1)} \qquad \ldots (20)$$

[Step 1-2]

Three values $(|Z_{m,n0}^{(1-1)}|, |Z_{m,n1}^{(1-1)}|, |Z_{m,n2}^{(1-1)}|)$ are selected from the smallest one of the calculated $|Z_{m,n}^{(1-1)}|$, where n0: minimum index, n1: minimum index except {n0}, and n2: minimum index except {n0, n1}.

[Step 1-3]

Following equation (21) is calculated by using the three values obtained above.

$$\delta_0 = \max(0.9 - (|Z_{m,n2}^{(1-1)}| - |Z_{m,n1}^{(1-1)}|)/2) \quad \Delta_0 = \max(|Z_{m,n1}^{(1-1)}| - \delta_0, 0)$$

$$\delta_1 = \max(0.9 - (|Z_{m,n2}^{(1-1)}| - |Z_{m,n0}^{(1-1)}|)/2), \quad \Delta_1 = \max(|Z_{m,n0}^{(1-1)}| - \delta_1, 0)$$

$$\delta_2 = \max(0.9 - (|Z_{m,n1}^{(1-1)}| - |Z_{m,n0}^{(1-1)}|)/2) \quad \Delta_2 = \max(|Z_{m,n0}^{(1-1)}| - \delta_2, 0)$$

$$\ldots (21)$$

[Step 1-4]

Following equations (22) and (23) are calculated by using a positive value and a negative value of $Z_{m,n}^{(1-1)}$.

$$[\text{Numerical Expression 13}]$$

$$S = \prod_{n \in N(m)} sgn(z_{m,n}(1-1)) \qquad \ldots (22)$$

$$e_{m,n}^{(1)} = S \cdot sgn(Z_{m,n}^{(1-1)}) \cdot \Delta_j$$

($\Delta_j$: select calculation result not related to own node

$$Z_{m,n}^{(1-1)}) \qquad \ldots (23)$$

[Step 1-5]
Calculate following equation (24) for $n \in N(m)$.

$$Z_n^{(1)} = Z_{m,n}^{(1-1)} + e_{m,n}^{(1)} \qquad \ldots (24)$$

Perform following processing as Step 2 (hard decision and discontinuation standard).

[Step 2-1]

Determine an estimated code word $c'=[c'_n]$ by using following equation (25).

$$c'_n = 1 \ \text{if} \ Z_n^{(1)} > 0$$

$$c'_n = 0 \ \text{if} \ Z_n^{(1)} \leq 0 \qquad \ldots (25)$$

[Step 2-2]
It is confirmed whether $c'=[c'_n]$ satisfies the parity check, and if $c'=[c'_n]$ satisfies the parity check, the processing finishes.
[Step 2-3]
It is confirmed whether the number of execution of Step 1 and Step 2 reaches the maximum repeat count, and if the number reaches the count, the processing finishes. Otherwise, the processing at Step 1-1 to Step 2-1 is repeated again.
The processing at Step 1 and Step 2 is repetitively executed until $c'=[c'_n]$ satisfies the parity check, or the number of execution of Step 1 and Step 2-1 reaches the maximum repeat count.

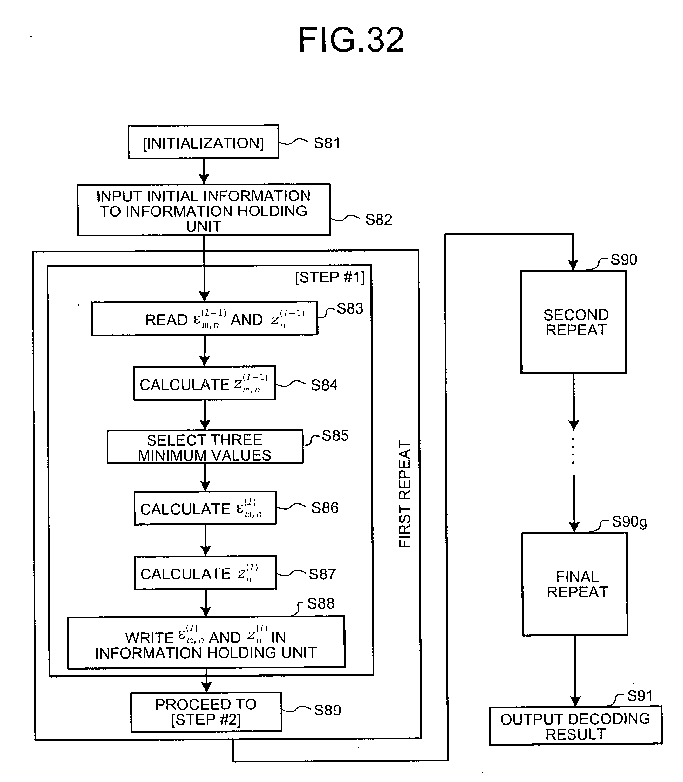

Fig. 32 is a flowchart of the processing of the decoding device according to the present embodiment. The operation of the decoding device is explained with reference to Fig. 31 and Fig. 32.
The LLR is first input as the received information, and the initializing unit 81 initializes the information holding unit 821 according to the algorithm initialization (initialization process) described above (Steps S81 and S82). The decoding core unit 82 then executes the processing (Step #1) according to Step 1 (update of the reliability information) of the algorithm. Specifically, the minimum value selector 822 reads $X_n^{(1-1)}$ and $e_{m,n}^{(1-1)}$ from the information holding unit 821 (Step S83), to calculate $Z_{m,n}^{(1-1)}$ (Step S84). The minimum value selector 822 then selects three smallest absolute values from the calculation result at Step S84 (Step S85). The updating unit 823 calculates $\Delta_j$ from the selected values, to calculate an update value of $e_{m,n}^{(1)}$ by using the positive value and the negative value of $Z_{m,n}^{(1-1)}$ (Step S86). Further, the updating unit 823 calculates an update value of $Z_n^{(1)}$ from the calculated $e_{m,n}^{(1)}$ (Step S87). Lastly, the updating unit 823 writes these (update values of $e_{m,n}^{(1)}$ and $Z_n^{(1)}$ in the information holding unit 821 (Step S88), to finish the process in the decoding core unit 82.
When the information update process in the decoding core unit 82 finishes, the hard decision unit 83 executes the process (Step #2) according to Step 2 (hard decision and discontinuation standard) of the algorithm. Specifically, the hard decision unit 83 executes $Z_n^{(1-1)}$ hard decision at Step 2-1 to obtain the estimated code word, performs parity check thereof and confirms the discontinuation standard of the repetition decoding (Step S89). If the discontinuation standard is satisfied, the hard decision unit 83 finishes the decoding process to output the decoding result (Step S91). Otherwise, the hard decision unit 83 repeats the process in the decoding core unit 82 (Step S90).
Thereafter, the repetition process is continued until the discontinuation standard is satisfied in the process corresponding to Step S89 in each repetition process (Step S90, ..., Step S90g), and after the repetition process finishes, the hard decision unit 83 outputs the decoding result (Step S91).
The present embodiment is based on input of the received LLR. However, received information after being decoded can be input to the decoding device, to calculate the received LLR in initialization of the decoding process. Further, in equation (21) showing the update process of the reliability information, an example in which the process is simplified by using up to a linear approximation term of a function predominant in the update according to Nonpatent Literature 4 is shown. However, an update equation in which approximation of another function, which is ignored in Nonpatent Literature 4 as not predominant, can be used so long as approximation is suitable for implementation.
According to the eighth embodiment, a mathematical function is simplified based on approximation, which has been difficult at the time of implementing the conventional "Horizontal Shuffled BP", thereby enabling to decrease complexity of implementation. Accordingly, a circuit size and power consumption can be reduced.
Ninth Embodiment.
A ninth embodiment is explained next. In the present embodiment, a communication system to which any one of decoding devices according to the first to eighth embodiments is applied is explained.

The LDPC encoding process and decoding process according to the present invention explained in the first to eighth embodiments can be applied to, for example, mobile communication (terminals and base stations), wireless LAN, optical communication, satellite communication, and general communication devices such as quantum cryptography devices. Specifically, a device that executes the encoding process and decoding process according to the present invention is mounted on each communication device to perform error correction.

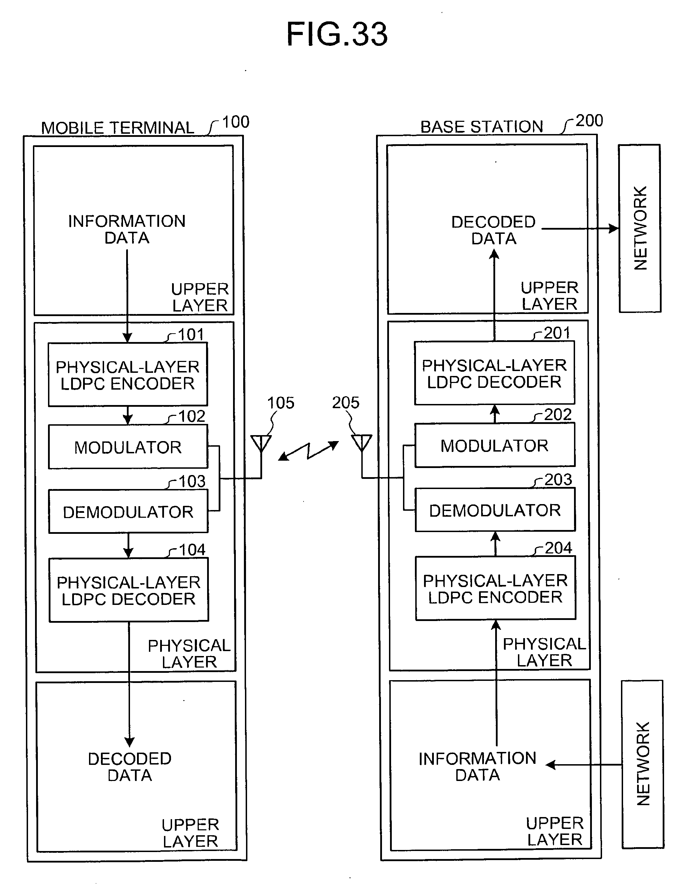

Fig. 33 is a configuration example of a mobile communication system to which the communication device according to the present invention is applied. In Fig. 33, a mobile terminal 100 includes, in a physical layer, a physical-layer LDPC encoder 101, a modulator 102, a demodulator 103, a physical-layer LDPC decoder 104, and an antenna 105. A base station 200 includes, in a physical layer, a physical-layer LDPC decoder 201, a demodulator 202, a modulator 203, a physical-layer LDPC encoder 204, and an antenna 205. The configuration of the LDPC encoder in the communication device explained in any one of the first to seventh embodiments is applied to the physical-layer LDPC encoders 101 and 204 in the mobile terminal 100 and the base station 200, and the configuration of the LDPC decoder in the communication device explained in any one of the first to seventh embodiments is applied to the physical-layer LDPC decoders 104 and 201 in the mobile terminal 100 and the base station 200.

In the mobile communication system configured as described above, an operation of the mobile terminal 100 for transferring information data via the base station 200 is explained. When the mobile terminal 100 transmits data, in the physical layer, the physical-layer LDPC encoder 101 for fading communication lines encodes transmission data (information data) in a unit of packet data. The encoded data is transmitted to a wireless communication line via the modulator 102 and the antenna 105.

On the other hand, the base station 200 receives a received signal including an error occurred in the wireless communication line via the antenna 205 and the demodulator 202, and the physical-layer LDPC decoder 201 performs error correction of the received data after demodulation, which is received from the demodulator 202. The physical-layer LDPC decoder 201 then advises an upper layer whether error correction executed in a unit of packet is successful. When the error correction is successful, the upper layer transfers the packet (information packet) including the information data as decoded data to a communication partner via a network.

When the mobile terminal 100 receives the information data from the network, the base station 200 transmits encoded data to the mobile terminal 100 by performing a process reverse to the information data transmission operation performed by the mobile terminal 100, and the mobile terminal 100 reproduces the received data.

Specifically, when the base station transmits the encoded data to the mobile terminal 100, in the physical layer, the physical-layer LDPC encoders 204 for fading communication lines encodes the transmission data (information data) in a unit of packet data. The encoded data is transmitted to the wireless communication line via the modulator 203 and the antenna 205. On the other hand, the mobile terminal 100 receives the received signal including an error occurred in the wireless communication line via the antenna 105 and the demodulator 103, and the physical-layer LDPC decoder 104 performs error correction of the received data after demodulation. The physical-layer LDPC decoder 104 then advises the upper layer whether error correction executed in a unit of packet is successful.

Thus, in the present embodiment, the communication device according to any one of the first to eighth embodiments is applied to the communication system (the base station and the mobile terminal). Accordingly, a communication system in which the error correction capability (decoding capability) is improved can be established.

INDUSTRIAL APPLICABILITY

The communication device according to the present invention is useful in the communication system, and particularly suitable for a communication device having an error correction function using the LDPC codes.

**Claims**

1. A communication device that transmits and receives LDPC-encoded information by using MIMO technology, the communication device comprising:

   a transmission sorting unit that sorts LDPC-encoded bits constituting the LDPC-encoded information in a descending order of column degree of a check matrix used for generating the LDPC-encoded bits; and
   a signal transmitting unit that transmits sorted LDPC-encoded bits sorted by the transmission sorting unit by allocating the sorted LDPC-encoded bits from a transmission line having a lower noise level in sorted order.

2. The communication device according to claim 1, further comprising a transmission-line determining unit that determines whether to allocate the sorted LDPC-encoded bits from a transmission line having a lower noise level in sorted order or to allocate the sorted LDPC-encoded bits from a transmission line having a higher noise level in sorted order, based on an encoding ratio of the LDPC-encoded information, wherein
the signal transmitting unit transmits the sorted LDPC-encoded bits according to a result of determination by the transmission-line determining unit.

3. A communication device that transmits and receives LDPC-encoded information by using MIMO technology, the communication device comprising:

   a signal transmitting unit that transmits, when an LDPC code has an LDGM structure, LDPC-encoded bits constituting the LDPC-encoded information by allocating the LDPC-encoded bits from an information bit to a transmission line having a lower noise level in order.

4. The communication device according to claim 3, further comprising a transmission-line determining unit that determines whether to allocate the LDPC-encoded bits from the information bit to a transmission line having a lower noise level in order or to allocate the LDPC-encoded bits alternately to a transmission line having a lower noise level and a transmission line having a higher noise level, based on an encoding ratio, wherein
the signal transmitting unit transmits the LDPC-encoded bits according to a result of determination by the transmission-line determining unit.

5. A communication device that transmits and receives LDPC-encoded information by using MIMO technology, the communication device comprising:

   a puncturing unit that punctures, based on an LDPC code having an encoding ratio of 1/2, parity bits of the LDPC code to adjust an encoding ratio and an encoded bit length such that the encoded bit length satisfies an encoded bit length required by a communication system; and
   a signal transmitting unit that transmits the LDPC code on which a puncturing is performed to a destination-side communication device.

6. The communication device according to claim 5, wherein the puncturing unit determines, when the encoding ratio is "power of two/(power of two+1)", puncturing positions such that unpunctured positions are arranged at regular intervals, and in cases of other encoding ratios, punctures the parity bits from its end in order such that the encoding ratio satisfies a required encoding ratio, with reference to a case of a smaller and closest encoding ratio of "power of two/(power of two+1)".

7. A communication device that transmits and receives LDPC-encoded information by using MIMO technology, the communication device comprising:

   a bit-length adjusting unit that inserts, when a size of a generator matrix of an LDPC code does not match an information bit length of transmission information required by a system, an adjustment bit into the transmission information such that the information bit length of the transmission information matches the size of the generator matrix; and
   an LDPC encoding unit that performs an LDPC encoding of the transmission information with the adjustment bit inserted, and removes an LDPC-encoded bit corresponding to the adjustment bit from an obtained LDPC code.

8. A communication device that transmits and receives LDPC-encoded information by using MIMO technology, the communication device comprising:

   a demodulating unit that demodulates an MIMO transmission signal that is a received signal; and
   a repetitive decoding unit that executes a row processing as a first decoding process with respect to a received LDPC code that is an output signal from the demodulating unit using a check matrix, executes a column processing as a second decoding process with respect to a result of the row processing, takes a column processing result obtained by executing the row processing with respect to a result of the column processing and the column processing with respect to a result of the row processing for a predetermined number of times as a final column processing result, and outputs a result obtained by performing a hard decision with respect to the final column processing result as a decoding result, wherein
   when the column processing is a column processing corresponding to parity bits and when a column degree of a check matrix is two, the repetitive decoding unit executes the column processing using a first algorithm having a less calculation amount than a normal column processing, and

when the column processing is a column processing corresponding to parity bits and when a column degree of a check matrix is one, the repetitive decoding unit executes the column processing using a second algorithm having a further less calculation amount.

9. A communication device that transmits and receives LDPC-encoded information by using MIMO technology, the communication device comprising:

a transmitter that executes a processing of the communication device according to claim 1; and
a receiver that executes a processing of the communication device according to claim 8.

10. A communication device that transmits and receives LDPC-encoded information by using MIMO technology, the communication device comprising:

a transmitter that executes a processing of the communication device according to claim 3; and
a receiver that executes a processing of the communication device according to claim 8.

11. A communication device that transmits and receives LDPC-encoded information by using MIMO technology, the communication device comprising:

a transmitter that executes a processing of the communication device according to claim 5; and
a receiver that executes a processing of the communication device according to claim 8.

12. A communication device that transmits and receives LDPC-encoded information by using MIMO technology, the communication device comprising:

a transmitter that executes processing of the communication device according to claim 7; and
a receiver that executes processing of the communication device according to claim 8.

13. A decoding device for a communication device that transmits and receives LDPC-encoded information by using MIMO technology, the decoding device comprising:

a repetitive decoding unit that executes a row processing as a first decoding process with respect to a received LDPC code that is an input signal using a check matrix, executes a column processing as a second decoding process with respect to a result of the row processing, takes a column processing result obtained by executing the row processing with respect to a result of the column processing and the column processing with respect to a result of the row processing for a predetermined number of times as a final column processing result, and outputs a result obtained by performing a hard decision with respect to the final column processing result as a decoding result, wherein
when the column processing is a column processing corresponding to parity bits and when a column degree of a check matrix is two, the repetitive decoding unit executes the column processing using a first algorithm having a less calculation amount than a normal column processing, and
when the column processing is a column processing corresponding to parity bits and when a column degree of a check matrix is one, the repetitive decoding unit executes the column processing using a second algorithm having a further less calculation amount.

14. An information transferring method used when transmitting and receiving LDPC-encoded information by using MIMO technology, the information transferring method comprising:

a transmission sorting step including a transmission-source communication device sorting LDPC-encoded bits constituting LDPC-encoded information in descending order of column degree of a check matrix used for generating the LDPC-encoded bits;
an information transmitting step including the transmission-source communication device transmitting sorted LDPC-encoded bits sorted at the transmission sorting step by allocating the sorted LDPC-encoded bits from a transmission line having a lower noise level in sorted order;
a reception sorting step including a transmission-destination (reception side) communication device executing a reverse processing to a sort processing executed at the transmission sorting step (reverse sorting) with respect to a reception signal received from the transmission-source communication device, based on information on the sort processing at the transmission sorting step obtained in advance, to restore original order of the reception signal.

**15.** The information transferring method according to claim 14, further comprising a transmission-line determining step including the transmission-source communication device determining whether to allocate the sorted LDPC-encoded bits from a transmission line having a lower noise level in sorted order or to allocate the sorted LDPC-encoded bits from a transmission line having a higher noise level in sorted order, based on an encoding ratio of the LDPC-encoded information.

**16.** An information transferring method used when transmitting and receiving LDPC-encoded information by using MIMO technology, the information transferring method comprising:

a signal transmitting step including a transmission-source communication device transmitting, when an LDPC code has an LDGM structure, LDPC-encoded bits constituting the LDPC-encoded information by allocating the LDPC-encoded bits from an information bit to a transmission line having a lower noise level in order.

**17.** The information transferring method according to claim 16, further comprising a transmission-line determining step including the transmission-source communication device determining whether to allocate the LDPC-encoded bits from the information bit to a transmission line having a lower noise level in order or to allocate the LDPC-encoded bits alternately to a transmission line having a lower noise level and a transmission line having a higher noise level, based on an encoding ratio, wherein
the signal transmitting step further includes the transmission-source communication device transmitting the LDPC-encoded bits according to a result of determination at the transmission-line determining step.

**18.** An information transferring method used when transmitting and receiving LDPC-encoded information by using MIMO technology, the information transferring method comprising:

a puncturing step including a transmission-source communication device puncturing, based on an LDPC code having an encoding ratio of 1/2, parity bits of the LDPC code to adjust an encoding ratio and an encoded bit length such that the encoded bit length satisfies an encoded bit length required by a communication system;
an information transmitting step including the transmission-source communication device transmitting the LDPC code on which a puncturing is performed to a transmission-destination communication device; and
a depuncturing step including the transmission-destination (reception side) communication device inserting a dummy bit into a reception signal received from the transmission-source communication device, based on information on a puncture processing obtained in advance, to restore an original bit position of the reception signal.

**19.** The information transferring method according to claim 18, wherein the puncturing step further includes the transmission-source communication device determining, when the encoding ratio is "power of two/(power of two+1)", puncturing positions such that unpunctured positions are arranged at regular intervals, and in cases of other encoding ratios, puncturing the parity bits from its end in order such that the encoding ratio satisfies a required encoding ratio, with reference to a case of a smaller and closest encoding ratio of "power of two/(power of two+1)".

**20.** An information transferring method used when transmitting and receiving LDPC-encoded information by using MIMO technology, the information transferring method comprising:

a bit-length adjusting step including a transmission-source communication device inserting , when a size of a generator matrix of an LDPC code does not match an information bit length of transmission information required by a system, an adjustment bit into the transmission information such that the information bit length of the transmission information matches the size of the generator matrix;
an LDPC encoding step including the transmission-source communication device performing an LDPC encoding of the transmission information with the adjustment bit inserted, and removing an LDPC-encoded bit corresponding to the adjustment bit from an obtained LDPC code; and
a decoding step including a transmission-destination communication device inserting a dummy bit to a same position as an insertion position of the adjustment bit with respect to a reception signal received from the transmission-source communication device to perform a decoding, and removing a decoding bit corresponding to the adjustment bit.

**21.** An information transferring method used when transmitting and receiving LDPC-encoded information by using MIMO technology, the information transferring method comprising:

a demodulating step of demodulating an MIMO transmission signal that is a received signal;
a row processing and column processing step of executing a row processing as a first decoding process with respect to a received LDPC code that is an output signal from the demodulating step using a check matrix, executing a column processing as a second decoding process with respect to a result of the row processing, and executing the row processing with respect to a result of the column processing and the column processing with respect to a result of the row processing for a predetermined number of times; and
a hard decision step of performing a hard decision with respect to a processing result at the row processing and column processing step, and outputting a result of hard decision as a decoding result, wherein
when the column processing is a column processing corresponding to parity bits and when a column degree of a check matrix is two, the row processing and column processing step includes executing the column processing using a first algorithm having a less calculation amount than a normal column processing, and
when the column processing is a column processing corresponding to parity bits and when a column degree of a check matrix is one, the row processing and column processing step includes executing the column processing using a second algorithm having a further less calculation amount.

22. A decoding method used when a communication device that transmits and receives LDPC-encoded information by using MIMO technology decodes an LDPC code, the decoding method comprising:

a row processing and column processing step of executing a row processing as a first decoding process with respect to a received LDPC code that is an input signal using a check matrix, executing a column processing as a second decoding process with respect to a result of the row processing, and executing the row processing with respect to a result of the column processing and the column processing with respect to a result of the row processing for a predetermined number of times; and
when the column processing is a column processing corresponding to parity bits and when a column degree of a check matrix is two, the row processing and column processing step includes executing the column processing using a first algorithm having a less calculation amount than a normal column processing, and
when the column processing is a column processing corresponding to parity bits and when a column degree of a check matrix is one, the row processing and column processing step includes executing the column processing using a second algorithm having a further less calculation amount.

# FIG.1

# FIG.2

CHECK MATRIX

```
1 1 1 0 1 1 0 0 0 0

0 1 1 1 0 1 1 0 0 0

1 1 1 1 0 0 1 1 0 0

0 1 0 1 0 1 0 1 1 0

1 1 0 1 1 0 0 0 1 1
```

COLUMN DEGREE:   3 5 3 4 2 3 2 2 2 1

ENCODED BITS   1 0 1 0 1 1 1 0 0 0

AFTER SORTING   0 0 1 1 1 1 1 0 0 0

# FIG.3

# FIG.4

# FIG.5

INFORMATION BITS

↓ ⌐S11

| PERFORM ENCODING |

| GENERATE SORT PATTERN |

↓ ⌐S12

| SORT ENCODED BITS | ◄———

SORT PATTERN

↓ ⌐S13

| ALLOCATE ENCODED BITS TO TRANSMISSION LINE | ◄——— COMMUNICATION LINE INFORMATION

↓↓↓↓ ⌐S14

| TRANSMIT ENCODED BITS |

TRANSMISSION LINE 1

↓↓↓↓ ⌐S15

| RECEIVE ENCODED BITS |

↓↓↓↓ ⌐S16

| CALCULATE RECEIVED LLR |

↓ ⌐S18a

| PERFORM DECODING |

| GENERATE SORT PATTERN |

DECODED BITS ↓ ⌐S17a

| SORT DECODED RESULT | ◄———

SORT PATTERN

↓

RESULT

# FIG.6

# FIG.7

# FIG.8

# FIG.9

# FIG.10

INFORMATION BITS

S11
PERFORM ENCODING

GENERATE
SORT PATTERN

S12
SORT ENCODED BITS

SORT PATTERN

S21
ENCODING
RATIO

ALLOCATE
ENCODED BITS TO
TRANSMISSION LINE

COMMUNICATION
LINE INFORMATION

S14
TRANSMIT
ENCODED BITS

TRANSMISSION
LINE 1

..

S15
RECEIVE
ENCODED BITS

S16
CALCULATE
RECEIVED LLR

S18a
PERFORM DECODING

GENERATE
SORT PATTERN

DECODED BITS

S17a
SORT DECODED BITS

SORT PATTERN

RESULT

# FIG.11

# FIG.12

# FIG.13

CORRESPONDING TO INFORMATION BITS    CORRESPONDING TO PARITY BITS

```
1 1 0 0 1 0 0 0 1 0 0 0 0 0 0 0
1 0 1 0 0 1 0 0 1 1 0 0 0 0 0 0
0 1 0 1 0 0 1 0 0 1 1 0 0 0 0 0
1 0 0 0 1 1 0 1 0 0 1 1 0 0 0 0
1 1 0 0 0 0 1 0 0 0 0 1 1 0 0 0
0 0 1 1 0 1 0 1 1 0 0 0 1 1 0 0
1 1 0 0 1 0 1 0 0 0 0 0 0 1 1 0
1 0 1 1 0 0 0 1 0 0 0 0 0 0 1 1
```

CHECK MATRIX HAVING LDGM STRUCTURE

# FIG.14

INFORMATION BITS  `1 1 1 0 1 0 1 1`

```
1 1 0 0 1 0 0 0 1 0 0 0 0 0 0 0
1 0 1 0 0 1 0 0 1 1 0 0 0 0 0 0
0 1 0 1 0 0 1 0 0 1 1 0 0 0 0 0
1 0 0 0 1 1 0 1 0 0 1 1 0 0 0 0
1 1 0 0 0 0 1 0 0 0 0 1 1 0 0 0
0 0 1 1 0 1 0 1 1 0 0 0 1 1 0 0
1 1 0 0 1 0 1 0 0 0 0 0 0 1 1 0
1 0 1 1 0 0 0 1 0 0 0 0 0 0 1 1
```

ENCODED ⇓

ENCODED BITS  `1 1 1 0 1 0 1 1 1 1 0 1 1 1 0 1`

TO TRANSMISSION LINE 1

TO TRANSMISSION LINE 2  ....

# FIG.15

INFORMATION BITS

↓ ⌐S11

| PERFORM ENCODING |

↓ ⌐S31

| ALLOCATE ENCODED BITS TO TRANSMISSION LINE | ◄——— COMMUNICATION LINE INFORMATION

↓ ↓ ↓ ↓ ⌐S14

| TRANSMIT ENCODED BITS |

↓ ↓ ↓ ↓

TRANSMISSION LINE 1 ⌐⌐⌐ ( ) ..

↓ ↓ ↓ ↓ ⌐S15

| RECEIVE ENCODED BITS |

↓ ↓ ↓ ↓ ⌐S16

| CALCULATE RECEIVED LLR |

↓ ⌐S18

| PERFORM DECODING |

↓

RESULT

## FIG.16

## FIG.17

# FIG.18

INFORMATION BITS

S11
PERFORM ENCODING

S31c
ALLOCATE
ENCODED BITS TO
TRANSMISSION LINE

ENCODING
RATIO

COMMUNICATION
LINE INFORMATION

S14
TRANSMIT
ENCODED BITS

TRANSMISSION
LINE 1

. .

S15
RECEIVE
ENCODED BITS

S16
CALCULATE
RECEIVED LLR

S18
PERFORM DECODING

RESULT

# FIG.19

Legend:
- 1/5 INFORMATION PREFERENTIAL ALLOCATION
- 1/5 ALTERNATE ALLOCATION
- 1/3 INFORMATION PREFERENTIAL ALLOCATION
- 1/3 ALTERNATE ALLOCATION
- 1/2 INFORMATION PREFERENTIAL ALLOCATION
- 1/2 ALTERNATE ALLOCATION
- 2/3 INFORMATION PREFERENTIAL ALLOCATION
- 2/3 ALTERNATE ALLOCATION

Y-axis: ERROR RATE (1.E+00, 1.E-01, 1.E-02, 1.E-03, 1.E-04, 1.E-05)
X-axis: Eb/N0 [dB] (-1.5, -0.5, 0.5, 1.5, 2.5, 3.5)

# FIG.20

11 LDPC ENCODER → 51 PUNCTURING UNIT → 13 SIGNAL TRANSMITTER → TRANSMISSION LINE → 14 SIGNAL RECEIVER → 52 DEPUNCTURING UNIT → 16 LDPC DECODER

# FIG.21

INFORMATION BITS | 1 1 1 0 1 0 1 1 |

PARITY BITS

ENCODED

ENCODED BITS
ENCODING RATIO 1/2 | 1 1 1 0 1 0 1 1 1 1 0 1 1 1 0 1 |

PUNCTURE

| 1 1 1 0 1 0 1 1 1 X 0 X 1 X 0 X |

TRANSMISSION BITS
ENCODING RATIO 2/3 | 1 1 1 0 1 0 1 1 1 0 1 0 |

TRANSMIT

RECEIVED LLR | $\lambda_0$ $\lambda_1$ $\lambda_2$ $\lambda_3$ $\lambda_4$ $\lambda_5$ $\lambda_6$ $\lambda_7$ $\lambda_8$ $\lambda_9$ $\lambda_{10}$ $\lambda_{11}$ |

DEPUNCTURE

| $\lambda_0$ $\lambda_1$ $\lambda_2$ $\lambda_3$ $\lambda_4$ $\lambda_5$ $\lambda_6$ $\lambda_7$ $\lambda_8$ 0 $\lambda_9$ 0 $\lambda_{10}$ 0 $\lambda_{11}$ 0 |

DECODE

DECODED BITS | 1 1 1 0 1 0 1 1 1 1 0 1 1 1 0 1 |

# FIG.22

INFORMATION BITS

↓ S51

| PERFORM ENCODING |

↓ S52

| PERFORM PUNCTURING | ◄─────NUMBER OF TRANSMISSION BITS

↓ S53

| TRANSMIT INFORMATION BITS |

⇓

↓ S54

| RECEIVE INFORMATION BITS |

↓ S55

| CALCULATE RECEIVED LLR |

↓ S56

| PERFORM DEPUNCTURING | ◄─────NUMBER OF TRANSMISSION BITS

↓ S57

| PERFORM DECODING |

↓

RESULT

# FIG.23-1

```
                    ┌─────────────┐
                    │    START    │
                    └─────────────┘
                           │
                           ▼
        ┌────────────────────────────────────┐
        │         READ r_{0,j}-TH BIT         │ ─── S52-1
        │ (0≦j<NUMBER INCLUDED IN BLOCK)      │
        └────────────────────────────────────┘
                           │
                           ▼
        ┌────────────────────────────────────┐
        │            t=q, p=t/2               │ ─── S52-2
        └────────────────────────────────────┘
                           │
                           ▼
        ┌────────────────────────────────────┐
        │         READ r_{p,j}-TH BIT         │ ─── S52-3
        │ (0≦j<NUMBER INCLUDED IN BLOCK)      │
        └────────────────────────────────────┘
                           │
                           ▼
        ┌────────────────────────────────────┐
        │               p=p+t                 │ ─── S52-4
        └────────────────────────────────────┘
                           │
                           ▼          S52-5
                    ╱──────────────╲      YES
                   ╱     p≧k?        ╲────────────┐
                   ╲                 ╱            │
                    ╲──────────────╱             ▼   S52-6
                           │ NO        ┌──────────────────┐
                           │           │    t=t/2, p=t/2  │
                           │           └──────────────────┘
                           ▼◄─────────────────┘
               S52-7  ╱──────────────╲
         NO   ╱         t=1?           ╲
       ◄─────╲                         ╱
              ╲──────────────────────╱
                           │ YES
                           ▼
        ┌────────────────────────────────────┐
        │ OUTPUT INFORMATION BITS AND n-k     │
        │ BITS FROM HEAD OF READ PARITY BIT   │ ─── S52-8
        │          AS ENCODED BITS            │
        └────────────────────────────────────┘
                           │
                           ▼
                    ┌─────────────┐
                    │     END     │
                    └─────────────┘
```

# FIG.23-2

PARITY BITS | 1000101010100001111··

| 1 | 0 | 0 | 0 | 1 | 0 | 1 | 0 |
| 1 | 0 | 1 | 0 | 0 | 0 | 0 | 1 |
| 1 | 1 | 1 | ·· |   |   |   |   |
|   |   |   |   |   |   |   |   |
|   |   |   |   |   |   |   |   |
|   |   |   |   |   |   |   |   |
|   |   |   |   |   |   |   |   |
|   |   |   |   |   |   |   |   |

(1)

(3)

(2)

(5)

(6)

(7)

(4)

(8)

(1) TO (8) INDICATE
READ SEQUENCE

# FIG.24

# FIG.25

# FIG.26

INFORMATION BITS | 1 0 1 0 1 1 | ADJUSTMENT BITS

AFTER ADJUSTMENT | 1 0 1 0 1 1 0 0

GENERATOR MATRIX

```
1 1 0 0 1 0 0 0 1 0 0 0 0 0 0 0
1 0 1 0 0 1 0 0 1 1 0 0 0 0 0 0
0 1 0 1 0 0 1 0 0 1 1 0 0 0 0 0
1 0 0 0 1 1 0 1 0 0 1 1 0 0 0 0
1 1 0 0 0 0 1 0 0 0 0 1 1 0 0 0
0 0 1 1 0 1 0 1 1 0 0 0 1 1 0 0
1 1 0 0 1 0 1 0 0 0 0 0 0 1 1 0
1 0 1 1 0 0 0 1 0 0 0 0 0 0 1 1
```

ENCODED BITS INCLUDING ADJUSTMENT BITS | 1 0 1 0 1 1 <u>0 0</u> 1 1 0 1 1 1 1

REMOVE

ENCODED BITS | 1 0 1 0 1 1 0 1 0 1 1 1 1

RECEIVED LLR | $\lambda_0$ $\lambda_1$ $\lambda_2$ $\lambda_3$ $\lambda_4$ $\lambda_5$ $\lambda_6$ $\lambda_7$ $\lambda_8$ $\lambda_9$ $\lambda_{10}$ $\lambda_{11}$ $\lambda_{12}$ $\lambda_{13}$

ADJUSTED LLR

AFTER ADJUSTMENT | $\lambda_0$ $\lambda_1$ $\lambda_2$ $\lambda_3$ $\lambda_4$ $\lambda_5+\infty$ $+\infty$ $\lambda_6$ $\lambda_7$ $\lambda_8$ $\lambda_9$ $\lambda_{10}$ $\lambda_{11}$ $\lambda_{12}$ $\lambda_{13}$

CHECK MATRIX

```
1 1 0 0 1 0 0 0 1 0 0 0 0 0 0 0
1 0 1 0 0 1 0 0 1 1 0 0 0 0 0 0
0 1 0 1 0 0 1 0 0 1 1 0 0 0 0 0
1 0 0 0 1 1 0 1 0 0 1 1 0 0 0 0
1 1 0 0 0 0 1 0 0 0 0 1 1 0 0 0
0 0 1 1 0 1 0 1 1 0 0 0 1 1 0 0
1 1 0 0 1 0 1 0 0 0 0 0 0 1 1 0
1 0 1 1 0 0 0 1 0 0 0 0 0 0 1 1
```

DECODE

DECODED BITS INCLUDING ADJUSTMENT | 1 0 1 0 1 <u>1 0</u> 0 1 1 0 1 1 1 1

REMOVE

DECODED RESULT | 1 0 1 1 1

# FIG.27

INFORMATION BITS

↓ ╭S61

INSERT ADJUSTMENT BIT

↓ ╭S11

PERFORM ENCODING

↓ ╭S62

REMOVE ADJUSTMENT BIT

↓ ╭S14

TRANSMIT ENCODED BITS

⇩

↓ ╭S15

RECEIVE ENCODED BITS

↓ ╭S16

CALCULATE RECEIVED LLR

↓ ╭S63

INSERT ADJUSTED LLR

↓ ╭S18

PERFORM DECODING

↓ ╭S64

REMOVE ADJUSTED PART

↓

RESULT

# FIG.28

```
DECODING
DEVICE
                    ┌─────────────────────┐ ⌐72
                    │  COLUMN             │
                    │  PROCESSOR          │
       ┌──────────┐ │        ⌐72-1        │  ┌──────────┐
       │          │ │  ┌───────────────┐  │  │          │
RECEIVED │  ROW    │ │  │   COLUMN      │  │  │  HARD    │  DECODING
LLR   ──→│PROCESSOR│→│  │  PROCESSOR    │  │→ │ DECISION │→  RESULT
       │          │←│  └───────────────┘  │  │  UNIT    │
       │          │ │        ⌐72-2        │  │          │
       └──────────┘ │  ┌───────────────┐  │  └──────────┘
           ∫        │  │   COLUMN      │  │       ∫
           71       │  │  PROCESSOR    │  │       73
                    │  └───────────────┘  │
                    │        ⌐72-3        │
                    │  ┌───────────────┐  │
                    │  │   COLUMN      │  │
                    │  │  PROCESSOR    │  │
                    │  └───────────────┘  │
                    └─────────────────────┘
```

# FIG.29

```
                    ┌───────────┐
                    │   START   │
                    └───────────┘
                  m=0      │ ←───────────────────┐←┐
                           ▼                     │ │
              ┌─────────────────────────┐        │ │
              │  EXECUTE ROW PROCESSING  │ ⌐S71   │ │
              └─────────────────────────┘        │ │
                           │            ⌐S72   m++│ │
                           ▼                      │ │
                    ◇ IS ROW NUMBER m ◇──NO───────┘ │
                    ◇ EQUAL TO M-1?  ◇              │
                           │ YES                    │
                  n=0      │ ←──────────────────┐   │
                           ▼                    │   │
              ┌─────────────────────────┐       │   │
              │ DETERMINE COLUMN DEGREE  │ ⌐S73  │   │
              └─────────────────────────┘       │   │
COLUMN                     │                     │   │
DEGREE IS 3 OR     ┌───────┼───────┐             │   │
HIGHER    ⌐S74-1   │  2    │⌐S74-2 │  1  ⌐S74-3  │   │
      ┌──────────┐ ┌──────────┐ ┌──────────┐     │   │
      │ EXECUTE  │ │ EXECUTE  │ │ EXECUTE  │      │   │
      │ COLUMN   │ │ COLUMN   │ │ COLUMN   │      │   │
      │ PROCESS A│ │ PROCESS B│ │ PROCESS C│      │   │
      └──────────┘ └──────────┘ └──────────┘      │   │
           └───────────┼────────────┘             │   │
                       │            ⌐S75       n++ │   │
                       ▼                           │   │
                ◇ IS COLUMN NUMBER n ◇──NO─────────┘   │
                ◇ EQUAL TO N-1?     ◇                  │
                       │ YES                           │
                       ▼              ⌐S76             │
             ◇ HAS REPETITION NUMBER ◇──NO─────────────┘
             ◇ REACHED MAXIMUM NUMBER◇
             ◇ OF TIMES?            ◇
                       │ YES    ⌐S77
              ┌─────────────────────────┐
              │  GENERATE HARD DECISION  │
              └─────────────────────────┘
                       │
                ┌───────────┐
                │  RESULT   │
                └───────────┘
```

## FIG.30-1

ADDITION: TWICE
SUBTRACTION: ONCE

## FIG.30-2

ADDITION: TWICE

## FIG.30-3

ADDITION: ONCE

## FIG.30-4

NONE

# FIG.31

INITIALIZING UNIT — 81

82

822

MINIMUM VALUE
SELECTOR

821

INFORMATION
HOLDING UNIT

823

UPDATING UNIT

DECODING CORE UNIT

HARD DECISION
UNIT — 83

# FIG.32

[INITIALIZATION] — S81

INPUT INITIAL INFORMATION TO INFORMATION HOLDING UNIT — S82

[STEP #1]

READ $\varepsilon_{m,n}^{(l-1)}$ AND $z_n^{(l-1)}$ — S83

CALCULATE $z_{m,n}^{(l-1)}$ — S84

SELECT THREE MINIMUM VALUES — S85

CALCULATE $\varepsilon_{m,n}^{(l)}$ — S86

CALCULATE $z_n^{(l)}$ — S87

WRITE $\varepsilon_{m,n}^{(l)}$ AND $z_n^{(l)}$ IN INFORMATION HOLDING UNIT — S88

PROCEED TO [STEP #2] — S89

FIRST REPEAT

SECOND REPEAT — S90

FINAL REPEAT — S90g

OUTPUT DECODING RESULT — S91

# FIG.33

# FIG.34

ANTENNA

SIGNAL 1,
SIGNAL 2 → TRANSMIT

RECEIVE → SIGNAL 1',
SIGNAL 2'

## INTERNATIONAL SEARCH REPORT

| | International application No. |
|---|---|
| | PCT/JP2007/055224 |

A. CLASSIFICATION OF SUBJECT MATTER
*H03M13/19(2006.01)i, H03M13/47(2006.01)i, H04J15/00(2006.01)i*

According to International Patent Classification (IPC) or to both national classification and IPC

B. FIELDS SEARCHED

Minimum documentation searched (classification system followed by classification symbols)
H03M13/19, H03M13/47, H04J15/00

Documentation searched other than minimum documentation to the extent that such documents are included in the fields searched
Jitsuyo Shinan Koho        1922-1996   Jitsuyo Shinan Toroku Koho   1996-2007
Kokai Jitsuyo Shinan Koho   1971-2007   Toroku Jitsuyo Shinan Koho   1994-2007

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| A | JP 2005-160106 A  (Lucent Technologies Inc.), 16 June, 2005 (16.06.05), Full text; all drawings & US 2005/0111564 A1     & EP 1538773 A2 & KR 2005050606 A        & IN 200401268 I4 | 1-4,14-17 |
| A | JP 2005-277784 A  (Toshiba Corp.), 06 October, 2005 (06.10.05), Full text; all drawings & US 2005/0216821 A1     & CN 1674447 A & JP 3875693 B2 | 1-4,14-17 |

☐ Further documents are listed in the continuation of Box C.          ☐ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| 12 June, 2007 (12.06.07) | 26 June, 2007 (26.06.07) |

| Name and mailing address of the ISA/ | Authorized officer |
|---|---|
| Japanese Patent Office | |
| Facsimile No. | Telephone No. |

Form PCT/ISA/210 (second sheet) (April 2005)

52

**EP 1 998 454 A1**

<table>
<tr><td>**INTERNATIONAL SEARCH REPORT**</td><td>International application No.<br>PCT/JP2007/055224</td></tr>
</table>

**Box No. II     Observations where certain claims were found unsearchable (Continuation of item 2 of first sheet)**

This international search report has not been established in respect of certain claims under Article 17(2)(a) for the following reasons:

1. ☐ Claims Nos.:
    because they relate to subject matter not required to be searched by this Authority, namely:

2. ☐ Claims Nos.:
    because they relate to parts of the international application that do not comply with the prescribed requirements to such an extent that no meaningful international search can be carried out, specifically:

3. ☐ Claims Nos.:
    because they are dependent claims and are not drafted in accordance with the second and third sentences of Rule 6.4(a).

**Box No. III     Observations where unity of invention is lacking (Continuation of item 3 of first sheet)**

This International Searching Authority found multiple inventions in this international application, as follows:

See extra sheet.

1. ☐ As all required additional search fees were timely paid by the applicant, this international search report covers all searchable claims.

2. ☐ As all searchable claims could be searched without effort justifying an additional fee, this Authority did not invite payment of any additional fee.

3. ☐ As only some of the required additional search fees were timely paid by the applicant, this international search report covers only those claims for which fees were paid, specifically claims Nos.:

4. ☒ No required additional search fees were timely paid by the applicant.   Consequently, this international search report is restricted to the invention first mentioned in the claims; it is covered by claims Nos.: 1-4, 14-17

**Remark on Protest**
the
☐ The additional search fees were accompanied by the applicant's protest and, where applicable, payment of a protest fee..

☐ The additional search fees were accompanied by the applicant's protest but the applicable protest fee was not paid within the time limit specified in the invitation.

☐ No protest accompanied the payment of additional search fees.

Form PCT/ISA/210 (continuation of first sheet (2)) (April 2005)

| INTERNATIONAL SEARCH REPORT | International application No. |
|---|---|
| | PCT/JP2007/055224 |

Continuation of Box No.III of continuation of first sheet(2)

The requirement of unity of invention in the international application (PCT Rule 13.1) is satisfied as is stipulated in PCT Rule 13.2 only when there is a technical relationship among the inventions of claims involving one or more of the same or corresponding special technical features (technical features of respective inventions as a whole explicitly making contribution over the prior art).

When the inventions of claims 1-22 are studied, the technical feature common to these claims relates to "a communication device (an information transmission method) for transmitting/receiving LDPC-encoded information by using the MIMO technique".

However, this technical feature is disclosed in JP 2005-160106 A and is only a known technique.
Accordingly, "the communication device (the information transmission method) for transmitting/receiving LDPC-encoded information by using the MIMO technique" makes not contribution over the prior art and cannot be a special technical feature within the meaning of the aforementioned rule.

Accordingly, the present application is divided into four groups of inventions: the inventions of claims 1-2, 3-4, 14-15, 16-17, the inventions of claims 5-6, 18-19, the inventions of claims 7, 20, and the inventions of claims 8-12, 13, 21, 22.

Form PCT/ISA/210 (extra sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 2005277784 A

- JP 2005039585 A

### Non-patent literature cited in the description

- 100Mbit/s SDM-COFDM over MIMO Channel for Broadband Mobile Communications. *Technical Report of IEICE RCS2001-135,* October 2001, 37-42
- Low-density parity-check codes and their decoding method LDPC (Low Density Parity Check) codes/sum-product decoding method. *Triceps,* 05 June 2002, 76-99

- **F. GUILLOUD.** *Generic architecture for LDPC codes, http://pastel.paristech.org/archive/00000806/01/these*
- **L. SAKAI ; W. MATSUMOTO ; H. YOSHIDA.** *Low Complexity Decoding Algorithm for LDPC Codes and Its Discretized Density Evolution,* July 2005, 13-18